(19) Europäisches Patentamt
European Patent Office
Office européen des brevets

(11) Publication number: **0 225 488 B1**

(12) **EUROPEAN PATENT SPECIFICATION**

(45) Date of publication of patent specification: **16.02.94**

(51) Int. Cl.⁵: **G06F 1/03**, G06F 7/52, H03M 7/40

(21) Application number: **86115454.0**

(22) Date of filing: **07.11.86**

(54) **Log encoding/decoding method.**

(30) Priority: **04.12.85 US 805157**

(43) Date of publication of application:
**16.06.87 Bulletin 87/25**

(45) Publication of the grant of the patent:
**16.02.94 Bulletin 94/07**

(84) Designated Contracting States:
**DE FR GB IT**

(56) References cited:
**US-A- 3 875 344**
**US-A- 4 286 256**

**IBM TECHNICAL DISCLOSURE BULLETIN, vol. 27, no. 6, November 1984, pages 3380-3381, New York, US; J.C. VERMEULEN: "logarithmic counter array fast access"**

**IBM Journal Res. Dev., vol. 28, no. 2, March 1984, pages 135-149, New York, US; G.G. Langdon Jr.: "An Introduction to arithmetic coding"**

(73) Proprietor: **International Business Machines Corporation**
**Old Orchard Road**
**Armonk, N.Y. 10504(US)**

(72) Inventor: **Mitchell, Joan LaVerne**
**Seven Cherry Hill Circle**
**Ossining, N.Y. 10562(US)**
Inventor: **Pennebaker, William Boone**
**R.D. 12, Crane Road**
**Carmel, N.Y. 10512(US)**
Inventor: **Goertzel, Gerald**
**Seven Sparrow Circle**
**White Plains, N.Y. 10605(US)**

(74) Representative: **Teufel, Fritz, Dipl.-Phys. et al**
**IBM Deutschland Informationssysteme GmbH,**
**Patentwesen und Urheberrecht**
**D-70548 Stuttgart (DE)**

**EP 0 225 488 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

FIELD OF THE INVENTION

In general, the present invention involves encoding and decoding data by using logarithms. In particular, the invention relates to encoding and decoding in an arithmetic coding system which compresses data during coding and de-compresses data during decoding, wherein at least some of the computations are performed in the logarithmic domain.

BACKGROUND OF THE INVENTION

One technique of compressing and de-compressing data is known as arithmetic coding. Arithmetic coding provides that, during encoding, the results of a set of events are made to correspond to a respective point on a number line and, during decoding, the results from the set of events can be re-determined from a knowledge of the respective point. Specifically, during encoding the occurrence of a first answer for an event (or decision) is related to a corresponding first interval along the number line. The occurrence of a second (subsequent) event is associated with a subinterval along the first interval. With additional events, successive subintervals are determined. The final subinterval is represented by a selected point, which is defined as a compressed data stream. For a given set of answers for a respective set of decisions, only one subinterval with one corresponding compressed data stream is defined. Moreover, only one set of answers can give rise to a given compressed data stream.

Hence, given the compressed data stream, the original set of answers can be determined during decoding.

When the possible number of answers which can occur at any given event is two, the arithmetic coding is binary. One example of a binary application is embodied in the processing of white/black data of a picture element (pel) of a facsimile processing system. In the facsimile application, there are two complementary probabilities referred to herein as "P" and "Q". Given that a pel can be either black or white, one probability corresponds to a pel being black and the other corresponds to the pel being white. Such an environment is discussed in an article by Langdon, "An Introduction to Arithmetic Coding", IBM J. Res. Develop. Vol 28, No 2, pages 135-149 (March, 1984).

As noted in the article one of the two possible answers in binary coding may be more likely than the other at a given time. Moreover, from time to time, which of the two answers is more likely may switch. In a black background, for example, the probability of the "black" should be significantly greater than for the "white" answer, whereas in a white background the "white" answer should be more likely. In the Langdon article, an approach is proposed which may be applied to a binary arithmetic code or, more generally, to a multisymbol alphabet environment. In each case, the approach involves processing numerical data in the real number system. Specifically, the encoding process is described as defining a variable C (representing a code point along the number line) and an expression $C+A$ (representing an available space starting at the current code point C and extending a length A along the number line). The interval A is sometimes referred to as the range. In the binary context, Langdon represents the variable A in floating point notation.

Other references of a related nature include two patents, U.S. Patents 4467317 and 4286256. An article by Rissanen and Langdon, "Arithmetic Coding", IBM J. Res. Develop. Vol 23, No 2, pages 149-162 (March 1979), also discusses arithmetic coding. In the Langdon and Rissanen-Langdon articles and in the above-referenced patents, which are incorporated herein by reference, additional patents and publications are discussed which may serve as further background to the present invention.

The prior mentioned article "An Introduction to Arithmetic Coding" by Langdon published in IBM Journal of Research and Development Vol. 28 No.2 March 1984 describes coding and decoding with probabilities. In the so-called length or L-based arithmetic code logarithms are used to represent a measure of the width of the code space. It is further mentioned that for n symbols a M-by-n table of values might be precalculated. It is not stated that such a table has been realised in practice probably because of the precision requirements of arithmetic coding.

The use of logarithms for re-computing range is not straightforward because of the precision requirements of arithmetic coding. Specifically, when transferring from the real number domain to a logarithm domain in which there is finite precision, the resulting logarithm includes some truncation due to the finite precision requirement. A problem attending the truncation involves the antilogs that are to be subsequently taken. Due to the truncation, it is possible for the sum of the antilogs of log P and log Q to exceed one --resulting in ambiguity which cannot be tolerated in the arithmetic coding. Stated otherwise, the truncation operation must be performed to assure decodability. Until the present invention, this feature has not been achieved with a log coder.

SUMMARY OF THE INVENTION

Hence, it is a major object of the present invention to provide an arithmetic coding encoder/decoder system in which probabilities are represented in the logarithmic domain with finite precision.

In achieving the above-noted object, prescribed log tables and an antilog table are employed. In accordance with the present invention, the antilog cable is generated in accordance with specific constraints applied in working with fractions employed in the encoding and decoding process.

The invention further provides a method of reduction of the size of the tables to a well handable number of entries while keeping the coding inefficiency low.

In the case of a binary event (or decision), the more probable symbol has a probability P and the other (less probable) symbol has a probability Q. A range R is defined along a number line wherein R defines the limits in which a point is to be located. As recognized in the previous technology, a "new" range R' has been defined as the current range R multiplied by a symbol probability such as P. The new range R' would thus be R*P --where * indicates multiplication-- and corresponds to a reduction in the range R.

In accordance with the present invention, overlap of intervals along the number line is avoided by imposing the constraint:

$$R*P + R*Q \leqq R.$$

In the logarithmic domain, this condition becomes:

$$\frac{\text{antilog(log R+log P)}}{\text{antilog(log R)}} + \frac{\text{antilog(log R+log Q)}}{\text{antilog(log R)}} \leq 1$$

Based on the above relationships, the following constraints apply:

$$\frac{\text{antilog(log R+log P)}}{\text{antilog(log R)}} \leq \text{antilog(log P)}$$

and

$$\frac{\text{antilog(log R+log Q)}}{\text{antilog(log R)}} \leq \text{antilog(log Q)}$$

From the above-discussed relationships, a general condition is defined as:

$$\text{antilog}(\alpha + \beta) \leqq \text{antilog}(\alpha) * \text{antilog}(\beta)$$

where $\alpha$ and $\beta$ represent any two mantissas which correspond to inputs to an antilog table.

An antilog table formed according to the general condition set forth immediately hereinabove applies whether $\alpha$ corresponds to log R and $\beta$ corresponds to log P or whether, for a real number product R*Q, $\alpha$ would be log R and $\beta$ would be log Q.

The present invention is accordingly able to achieve the object of modifying the range R --formed from a product of real numbers such as R*P or R*Q-- in the logarithmic domain where the antilog table employed has the above-noted general condition applied thereto.

The present invention achieves the further object of reducing the size of the antilog table by applying the above-noted general condition in only certain cases while applying a different condition in other cases. That is, the antilog table outputs are limited to achieve reduced size based on the following two relationships:

$$\text{antilog}(\alpha + \beta) \leqq \text{antilog}(\alpha) * \text{antilog}(\beta) \; ; \; \alpha + \beta < 1$$
$$2 * \text{antilog}(\alpha + \beta - 1) \leqq \text{antilog}(\alpha) * \text{antilog}(\beta) \; ; \; \alpha + \beta \geqq 1$$

A further object of the present invention is the assuring of decodability. This object is achieved by imposing a constraint in addition to the above two relationships. According to this added constraint, all output values of the antilog table must be unique.

With decodability assured, the logarithm domain is employed to convert multiplications and divisions in the real number domain into additions and subtractions in the logarithmic domain. This achieves the object of reducing computational requirements.

The present invention also provides for controlled rounding in the log table used in converting to the log domain in order to guarantee correct identification of the least probable symbol in the decoder while still in the log domain.

Also according to the invention, optimized matched pairs of log P and log Q are determined for finite precision (and decodable) operation.

Furthermore, the present invention enables the collapse of the log P's to an optimal set for the given precision.

Further reduction of the log P table is achieved with an upper limit placed on the maximum coding error at least over a range of actual probabilities.

The present invention also provides for the encoding of successive occurrences of the most probable symbol in a given state of constant probability by a simple counting procedure.

Moreover, the present invention provides for byte, rather then bit, oriented input/output of compressed data with minimal testing.

In addition to the above-mentioned features and objects achieved by the present invention, the present logarithmic encoder/decoder addresses difficulties recognized as generally affecting arithmetic coding compression/de-compression systems.

The above cited objects are solved by the characterising features of claim 1.

Embodiments of the invention are defined in claims 2 to 4.

## BRIEF DESCRIPTION OF THE DRAWINGS

Fig. 1 is a diagram illustrating the basic structure of a compression/de-compression system including a log coder and log decoder.

Fig. 2 is an illustration showing a piece of number line divided into segments, one corresponding to the most (more) probable symbol and the other segment corresponding to the least (less) probable symbol.

Fig. 3 is a flowchart showing an encoder and decoder in an arithmetic coding compression/de-compression system.

Fig. 4 is a flowchart remapping the structure of Fig. 3 to a log coder implementation.

Fig. 5 is a graph depicting coding inefficiency relative to the entropy limit for all possible LP values for a sample probability interval. $P_{\langle LPS \rangle}$ has the same meaning as Q and LP represents the log2 ($1/P_{MPS}$).

Fig. 6 is a graph depicting coding inefficiency relative to the entropy limit for an optimum set of LP values for a sample probability interval.

Fig. 7 is a graph depicting coding error relative to the entropy limit for a reduced set of LP values for a sample probability interval.

Fig. 8 is a graph depicting coding error relative to the entropy limit for all 48 LP values in the reduced set.

Fig. 9 is a flowchart illustrating the operations of a log coder according to the present invention.

Fig. 10 is a flowchart illustrating the operations of a log decoder according to the present invention.

Figs. 11 through 31 are routines employed in the log coder or decoder or both to perform the arithmetic coding in accordance with the invention.

DESCRIPTION OF THE INVENTION

## I. Introduction

Section II of this disclosure discusses some basic principles of arithmetic coding that pertain to the implementation of a log coder. Section III develops the basic mathematical rules for arithmetic coding in the log domain, and therefore the rules by which the various antilog and log tables must be generated. Section IV discusses more detailed aspects of an actual implementation, dealing with such practical aspects as changing the state being coded, renormalization, carry propagation, and byte oriented input/output. It also describes the implementation of a probability adaptation concept described in a co-pending European patent application 86115453.2 of W.B. Pennebaker and J.L. Mitchell, co-inventors of the present invention, entitled "Probability Adaptation for Arithmetic Coders" filed on even date herewith. Section V describes tests of the functioning encoder and decoder.

## II. Basic Principles of Arithmetic Coding as Applied to Log Coding

Referring to Fig. 1, the basic structure of a compression/de-compression system 100 is shown. The encoder 102 is divided into two basic parts, a state generator 104 and a log coder 106. The decoder 110 is the inverse of this, including a log decoder 112 and a state generator 114. The state generator 104 contains a model which classifies input data into a set of binary context states which are, in general, history dependent.

The state generator 104 communicates to the log coder 106 the context state for the current binary decision. A similar context state output is provided by the state generator 114 for the decoder.

The context state, it is noted, identifies the most probable symbol (MPS); stores an index value I corresponding to a probability value in a lookup table; stores a count (i.e., the k count) representing the number of occurrences of the LPS symbol; and stores a count (i.e., the n count) representing the number of occurrences of either symbol. The YN (yes/no) output from the encoder state generator 104 informs the log coder 106 what the current binary symbol is.

In the example of a black/white facsimile system, the state generator 104 identifies a context state which is arrived at as the result of a particular pattern (or one of several patterns) of black/white pels. The actual next pel in the pattern is provided as a YN output.

The YN output from the log decoder 112 informs the decoder state generator 114 what the current symbol is. Using the YN value the decoder state generator 114 is able to reconstruct the output data.

The output from the log coder 106 is a single merged compressed data stream. Each context state, however, is encoded by the log coder 106 as if it were an independent entity. Preferably, the additional information is passed via the state which enables the encoder 102 and decoder 110 to perform calculations required for probability adaptation (such as is set forth in the aforementioned patent application filed on even date herewith). Combining the encoding/decoding method or apparatus of the present invention with the probability adaptation improves overall computational efficiency and compression performance. However, the present invention may be implemented in a system wherein probabilities are predetermined or are fixed and do not adapt with entry of new data. Hereinbelow, the present invention sets forth an embodiment employing probability adaptation.

In encoding a set of binary decisions, the present invention represents a point on the probability number line with sufficient precision to uniquely identify the particular sequence of symbols from all other possible sequences. The intervals on the number line are allotted according to the probabilities of the sequences. The more probable sequences are coded with less precision --i.e., with fewer bits -- and cover a larger interval.

A schematic of the mathematical operations for arithmetic coding based on infinite precision (rather then finite precision as in the present invention) is shown in Fig. 2. The symbol X(n-1) is an infinite precision compressed data stream generated in coding the n-1 prior binary decisions. X(n-1) points to the bottom of the range, along the number line, that is available to the nth symbol. R(n-1) is the range available for that symbol. The log decoder 106 uses the convention that the most probable symbol (MPS) and least probable symbol (LPS) are ordered such that the probability interval allotted to the MPS is below that of the LPS. Then, if the nth YN is an MPS, the point represented by X(n) remains fixed at the base of the interval and the range R(n) shrinks to that accorded the MPS. If the nth YN is an LPS, the MPS range is added to X(n-1) to shift the bottom point of the range X(n) to the base of the interval for the LPS and the range R(n) shrinks to that accorded the LPS. These two possibilities are shown graphically in Fig. 2.

Adopting the convention that the MPS occupies the lower part of the interval has computational advantages. In this regard, it is noted that the only information required for the coding process is a current compressed data stream X(n-1), a current range R(n-1) along the probability number line and a current MPS probability P. (The probability of the LPS, Q is by definition 1-P). As the nth symbol is stated, the current compressed data stream and interval are known. The current probability is determined from the context state information, i.e., the I value.

The basic principles of arithmetic coding discussed hereinabove are now considered in constructing an encoder and decoder. The problems relating to finite precision and carry propagation will be ignored for the moment.

A flow chart for an infinite precision arithmetic encoder and decoder is illustrated in Fig. 3. The encoder is identified at block 200 of the flow chart and the decoder is identified at block 210. Note that the oval blocks label the function which is performed by the flow chart.

The encoder first reduces the range from R to R*P at block 202. If an MPS is being encoded (at decision block 204), that is all that is required for that symbol. If an LPS is being encoded, the compressed data stream X is increased by R so that it points to the bottom of the new probability interval (see X(n) in Fig. 2 where YN ≠ MPS), and the range R is further reduced by multiplying by the ratio Q/P (Q being less than P by definition). These operations are performed at block 206. The coded data is in compressed form and may be transferred by any of various known elements 208 to the decoder.

The decoder operates in a manner analogous to the encoder. For each symbol being decoded, the decoder first reduces the current range R to R*P. The symbol YN is assumed to be an MPS, and is so set at block 212. If the compressed data stream X is determined at decision block 214 to be less than the new range R, the symbol must have been an MPS, and the decoder has successfully decoded the symbol. If this test fails, however, an LPS must be decoded. The YN symbol is switched to an LPS via an 'exclusive or' operation; the range allotted to the MPS subtracted from X; and --as in the encoder-- the new range is further reduced by the ratio Q/P in block 216.

The particular sequence of operations described in Fig. 3, it is noted, leads to a computationally efficient implementation relative to other valid operational sequences.

The remapping of Fig. 3 to a Log Coder and Log Decoder implementation is shown in Fig. 4. This is an overview of the function performed in the Log Coder 106 and Log Decoder 112 illustrated in Fig. 1. The logarithm of the current range, LR, is the measure of the probability interval available. LP is the log of the current MPS probability. The product, R*P, is therefore replaced by the sum of logarithms in block 302. Again, if YN is the MPS at decision block 304, the encoding operation is complete (conceptually). If YN is an LPS, the compressed data stream X must be increased by the antilog of the LR determined at step 302, and the log of the ratio of Q/P (LQP) must be added to LR as shown at block 306.

The decoder follows a similar structure. The range is first reduced, which in the log domain is done by adding two logarithms. (Preferably, the logarithms discussed in this embodiment are in base-2.) This is performed at block 308. The YN symbol is initially defined to be an MPS, and a test is made (in the log domain) to see if the compressed data stream X is less than the range determined in block 310. Note that LX and LR are logrithm magnitudes of numbers less than one. LX greater than LR means that X is less than R. If so, the log decoder is finished for that symbol. If not, the YN is converted to an LPS; the value of X is adjusted by subtracting the probability interval allotted to the MPS (ANTILOG(LR)); a new log X (denoted by LX) is calculated; and the log of the range LR is adjusted to match to the LPS range. These operations are performed at block 312.

This section has described the basic conceptual structure of the log coder and decoder. In this description the quantities LP and LQP were assumed to be looked up in tables from the context state information. In addition, the antilog calculation was assumed to be performed by a simple lookup table procedure. In making these assumptions, a number of very fundamental questions regarding finite precision arithmetic and guarantees of decodability have been side-stepped. These questions are addressed in the next section.

## III. Mathematical Principles and Generation of Tables for Arithmetic Coding in the Logarithmic Domain.

If decodability is to be guaranteed, there must never be any overlap of intervals along the probability number line. A necessary condition for this is:

$$P + Q \leqq 1 \qquad \text{Eq. 1}$$

In the log domain this becomes:

antilog (log P) + antilog (log Q) ≦ 1  Eq. 2

where the antilog is done by lookup tables which are generated subject to constraints described below.

The precision of log P is restricted to a given number of bits. For 10 bit precision log P can be regarded as being renormalized to convert it to a 10 bit integer having values from 1 to 1024. Since P is a fraction where 0.5 ≦ P < 1, log P is negative. For convenience, LP and LQ are defined as:

LP = 1024*(-log P)  Eq. 3a

LQ = 1024*(-log Q)  Eq. 3b

$$LQP = 1024 * (\log P - \log Q) = LQ - LP \qquad \text{Eq. 3c}$$

where the factor 1024 applies to 10 bit precision in the log tables.

Equation 2 is not a sufficient condition for decodability. In this regard, it is noted that in general, the range R is not 1, so equation 1 must be modified to:

R*P + R*Q ≦ R  Eq. 4

which in the log domain becomes:

antilog(log R + log P) + antilog(log R + log Q) ≦ antilog(log R)  Eq. 5

Dividing both sides of equation 5 by antilog(log R) gives:

$$\frac{\text{antilog}(\log R+\log P)}{\text{antilog}(\log R)} + \frac{\text{antilog}(\log R+\log Q)}{\text{antilog}(\log R)} \leq 1 \qquad \text{Eq. 5a}$$

In order for both equations 2 and 5 to always hold

$$\frac{\text{antilog}(\log R+\log P)}{\text{antilog}(\log R)} \leq \text{antilog}(\log P)$$

and

$$\frac{\text{antilog}(\log R+\log Q)}{\text{antilog}(\log R)} \leq \text{antilog}(\log Q)$$

Therefore, if in general

antilog($\alpha + \beta$) ≦ antilog($\alpha$) * antilog($\beta$)  Eq. 6

holds for the antilog table, equation 5 will be satisfied. Moreover, to achieve decodability, all output values of the antilog table must be unique.

Equation 6 represents a fundamental constraint on the structure of the antilog table.

To limit the size of the antilog table, equation 6 is revised slightly as follows.

$\text{antilog}(\alpha + \beta) \leqq \text{antilog}(\alpha) * \text{antilog}(\beta)$; where $\alpha + \beta < 1$    Eq. 7a

$2^*\text{antilog}(\alpha + \beta - 1) \leqq \text{antilog}(\alpha) * \text{antilog}(\beta)$; where $\alpha + \beta \geqq 1$    Eq. 7b

These two relationships are used in the generation of the antilog table, together with the one further constraint; namely, all output values of the antilog table must be unique, to achieve decodability and facilitated computation.

The antilog table is defined such that the log index is a number between 0 and 1, giving outputs between 1 and 2 (with proper renormalization of inputs and outputs). Although 14 bits are actually used in the antilog table, only 4096 entries are needed for the table. With the exception of the first entry in the table, the two most significant bits are always the same. Thus, it can be regarded as a 12 bit precision table. It is also noted that the non-linearities of the log and antilog tables and the uniqueness requirement demand that the precision of the antilog table be somewhat higher than the precision of the log table.

Once the antilog table is known, the log tables can be constructed. Two tables are required. As suggested in Fig. 4, both the encoder and decoder require a knowledge of log P and log Q/P. Given all possible values of log P (or LP), equation 2 can now be used to generate the values of log Q/P (LQP) which satisfy that constraint. While all values of log P are valid and decodable, the finite precision and constraints placed on the antilog table make many of the log P values non-optimum (as defined below).

For 10-bit precision, there are $2^{10}$ or 1024 possible estimated probabilities. This high number of probabilities is unwieldy. Hence, the number of probabilities is reduced according to appropriate criteria. In the present instance, estimated probabilities are discarded based on coding inefficiency. In this regard, it is noted that coding inefficiency is defined as:

$$\text{INEFFICIENCY} = \frac{\text{Bit Rate} - \text{Entropy}}{\text{Entropy}}$$

Entropy is equal -Plog2(P)-Qlog2(Q) where $P + Q = 1$ and is defined in terms of bits/symbol for ideal coding. Bit Rate is equal to $-P\log2(P_{est})- Q\log2(Q_{est})$ where $(Q_{est} + P_{est}) \leqq 1$ and is defined in terms of bits/symbol for an estimated probability (Bit Rate = Entropy represents the ideal condition).

Referring to Fig. 5, each curve corresponds to a probability estimate. Some curves have at least one point which, for a

$$\log2 \frac{1}{P_{LPS}}$$

abscissa value corresponding thereto, has a lower inefficiency value than any other curve. Some do not. Those estimated probabilities having curves that do not have a relative minimum inefficiency value are discarded as non-optimum. In Fig. 5, $P_{LPS}$ means Q and QL and QA represent the log and antilog precisions, respectively. The relative error is the coding inefficiency defined above.

After applying the "relative minimum criteria," the 1024 possible probabilities are reduced to 131. These 131 estimated probabilities may serve as entries in a table for estimated Q's.

A plot of relative coding inefficiency with respect to the entropy limit, (P*LP + Q*(LP + LQP)-Entropy)-/Entropy, is shown in Fig. 6 for a sample probability interval for the set of 131 remaining probabilities.

If slightly larger coding inefficiencies are allowed than the table would produce, the table can be further reduced. For example, deleting entries which can be replaced by neighboring entries without increasing the coding inefficiency to more than 0.2% further collapses the table to 48 entries. Fig. 7 shows this set for the same probability interval used for Fig. 6. Fig. 8 shows the coding inefficiency curves for all 48 entries.

In addition to the LP and LQP tables, the decoder also requires a log table in order to generate LX, the log of the current piece of the compressed data. This table must be structured so as to guarantee that the comparison of LX with LR will give exactly the same decision as a comparison of X with R. The following basic rules must be followed in constructing the LX table:

1. There must be an entry for every possible antilog value. Therefore, 4096 entries are required if the antilog table has 12 bit precision. Since only 10 bit precision is required in the log domain for this case, the table can be guaranteed to have all possible (1024) output values.

2. The LX table must be reversible for all values which are outputs of the antilog table. That is:

$$LX = \log(\text{antilog}(LX)) \qquad \text{Eq. 8}$$

3. Given an Xa and Xb as two adjacent output values from the antilog table, and an $X'$ such that $Xa > X' > Xb$, the output for $\log X'$ must be rounded down to log Xb. The reason for this is as follows:

For each Xc generated by the antilog table, if the bound between LPS and MPS occurs at Xc, Xc must be distinguished from Xc-1. If $X \geqq Xc$, an LPS has occurred, and if $X \leqq Xc-1$, an MPS has occurred. Therefore, for any given antilog table output, if X is slightly less than that output, log(X) should be rounded down to the log of the next antilog table output. If it were rounded up, it might be decoded as an LPS. Since the log(R) must be changed by at least one (i.e., by the smallest log P increment allowed) before decoding the next symbol, there is no danger that the next symbol might be erroneously decoded as an MPS.

## IV. Detailed Description of the Log Coder Operation.

### A. Definitions

LR is defined as 1024*(-log R), in keeping with the conventions used for LP and LQP. LR is a 16 bit integer, but can be considered a binary fraction with the binary point positioned to provide 10 fractional bits and 6 integer bits. LR serves a dual function; it is a measure of the current range and also a measure of the symbol count for probability adaptation. Probability adaptation is discussed in the previously cited patent application.

X contains the least significant bits of the compressed data stream for the encoder. In the encoder, X is a 32 bit word consisting of 12 integer bits and 20 fractional bits plus any carry. In the decoder only the 20 fractional bits are used and X is the current most significant bits after proper renormalization.

### B. LOG CODER (Fig. 9):

Fig. 9 shows a flow chart for an actual software implementation of the log coder. Some of the basic structure from Fig. 4 should be apparent, but there are significant additions. Before encoding a new symbol, a check is made to see if there is a new context state, NS, changed from the previous context state, S. The new context state is dictated by the model. By way of example, if the neighborhood identified with a pel changes from being predominantly black to predominantly white, a corresponding model would declare a new state (NS). Accordingly, a new set of parameters -- MPS I, k, and n (or the like) -- would be called.

CHANGESTATE (Fig. 11) is called to save and restore (a) a pointer to the probability table, (b) parameters required for probability adaptation, and (c) the MPS symbol. Once the context state is set, LR is increased by LP, as in Fig. 4. (Note the sign conventions for LR and LP.)

The adjusting of LR serves as a count indicator in the following way. If R is the current range and P is the MPS probability, the new range $R'$ after n events which happen to be MPS's is:

$$R' = R*P* \ldots P = R*P^n$$

In logarithmic form, this becomes:

$$\log R' = \log R + n\log P$$

which can also be represented as:

$$| \log R' | = | \log R | + n | \log P |$$

The number n is then set forth as:

$$n | \log P | = | \log R' | - | \log R |$$

Hence, the adjustment of R in logarithmic terms (i.e., LR) is in units of $| \log P |$. When nmaxlog P = n log P, the probability adaptation discussed herein and in the co-pending patent application is triggered. The YN decision is compared to MPS, and if an MPS has occurred, the coding is essentially complete. However, range checking must now be done to see if LR is too big. In this regard it is noted that event counting is performed in movements of log P rather than by 1. That is, instead of counting so that $n \leftarrow n+1$, the count for the MPS increments by log P with each occurrence of an MPS symbol. LR is compared to a quantity LRM, which is a measure of the total symbol count required before a meaningful check can be made on the current probability. If LR does reach LRM, a call is made to UPDATEMPS, where checks are made to see if a new (smaller Q) probability is required. The UPDATEMPTS routine is described in the co-pending application which, it is noted, is directed to a single context state.

If YN is not equal to MPS, an LPS has occurred. In this case the LPS counter, K, is incremented and a measure of the number of symbols encountered in the current block, DLRM, is saved. RENORM is then called to do any renormalization of LR and X required to guarantee that the integer part of LR is less than 8. After renormalization, ANTILOGX is called to calculate the amount DX which must be added to X to shift the compressed data to the base of the LPS probability interval. Then XCARRY is called to handle any carry which might have occurred when DX was added to X, and finally, UPDATELPS is called to take care of any probability adaptation (larger Q). LRM is then calculated from the saved DLRM and the new LR value.

C. LOG DECODER (Fig. 10):

The decoder also has some significant additions relative to the conceptual version of Fig. 4. As in the encoder, if the context state has been changed from the last decoder call, CHANGESTATE is invoked. A comparison measure LRT is specified as the smaller of LRM and LX. LRT must be updated if the context state is changed. LP is then added to LR to decrease the range, and the YN answer is defaulted to MPS. LR is then compared to LRT and, if smaller, the MPS symbol decode is complete. Since LRT is the smaller of LRM and LX, the comparison of LR against LRT serves a dual purpose. If LX is larger than LRM, passing the test means that the probability adaptation data block size was reached and that checking for probability adaptation must be done. If LX is not bigger than LR, either an LPS symbol has been decoded or renormalization is required. The count of symbols for the current data block is saved in DLRM and the range measure LR is then renormalized. If LX is still greater than LR (LX and LR are the magnitude of log X and log R), only a renormalization is needed. However, LR must still be compared to LRM in the event that UPDATEMPS is required.

If LX is equal to or less than LR, an LPS has been decoded. The LPS count, K --which is employed in probability adaptation-- is incremented; the YN answer is switched to LPS; and the antilog table is used to calculate DX, which is then subtracted from X. A new LX is then calculated; the probability adaptation code is called; and finally LRM is updated. For all paths which require a new value of LRM, UPDATELRT is called to calculate a new value of LRT.

D. CHANGESTATE (Fig. 11):

CHANGESTATE saves the total symbol count DLRST(S), required for the probability adaptation in that state. (The LPS count K and the pointer to the probability table -- i.e., log P, log Q/P, etc., -- are saved each time they are changed and do not need to be saved here). The pointer S is then shifted to the new context state NS. The LPS count K, the probability table pointer I, and the current MPS are restored. The value of the current log P is represented by LP (which is preferably saved in a register), and LRM is calculated from the current LR and the saved measure of the symbol count in this context state. LRMBIG is then called to do any renormalization that might be needed.

E. UPDATEMPS (Fig. 12):

UPDATEMPS checks to see if the probability needs to be adjusted. If the probability confidence measure so indicates, QSMALLER is called to adjust the probability table pointer to a smaller Q value. UPDATEMPS then resets the LPS count, K; stores the new value in KST(S); and adjusts the comparison value LRM to the end of the new block of symbols. LRMBIG is then called to see if any renormalization is required before proceeding.

F. QSMALLER (Fig. 13):

QSMALLER performs the probability adaptation as described in the co-pending cited patent application. Basically, if the LPS count K is too small, the probability table pointer I is adjusted to a new position (smaller Q) which restores confidence in the probability estimate. The last entry in the table of log P values is a zero. This is an illegal value which is used as a stop. If zero is encountered, the index is backed up to the last valid entry in the table. It is also noted that whenever I is changed, the new index is saved in the context state information. The value of LP must also be updated from LOGP(I).

G. RENORM -- for the log encoder (Fig. 14):

RENORM does the renormalization of LR and X, thus preventing LR from overflowing the allowed 15 bit range. Each time the characteristic part of LR (a log magnitude quantity) reaches or exceeds 8, one byte can be shifted from X to the compressed data stream buffer. The byte pointer BP is incremented to point to the next byte position; the high order byte in X is stored in B (byte pointed to by BP); and LR is decremented by the integer value of 8 (i.e., hex 2000). At that point the bytes remaining in X can be shifted left by 8 bits. Each time a new byte is added to the buffer, CHECKFFFF is called to see if a bit pattern of hex FFFF has been created in the buffer. If so, a byte must be stuffed in the buffer to block carry propagation. This is a form of bit stuffing as described in the aforementioned Rissanen-Langdon article entitled "Arithmetic Coding".

Each time a byte is added to the buffer a check is made to see if the buffer is full. If so, BUFOUT is called to transmit the contents of the buffer. This loop is repeated until the integer part of LR is less than 8.

H. ANTILOGX (Fig. 15):

ANTILOGX calculates the antilog of LR wherein DX --the amount which must be added to the code stream in the encoder and subtracted from the code stream in the decoder-- is obtained. The mantissa of LR (MR) is first obtained from the low 12 bits of LR. (Actually, 1-MR is the true mantissa, but the antilog table is inverted to avoid this subtraction). MR is used to index into the ANTILOG table (see function 'maketbls' in Appendix 1.) CT, the integer part of LR, is obtained by shifting LR right by 10 bits. The true characteristic would be calculated as 8-CT if one unit were not already imbedded in the MR value. Consequently, the output of the ANTILOG table only needs to be shifted by 7-CT to provide DX.

J. CHECKFFFF (Fig. 16):

As described earlier, CHECKFFFF looks for hex FFFF patterns on byte boundaries in the code stream. If the pattern is found, a zero byte is stuffed in the code stream following the FFFF pattern.

K. UPDATELPS (Fig. 17):

UPDATELPS is called when an LPS occurs. It first adjusts the range measure, LR, to that of the LPS. It then checks to see if probability adaptation is required by comparing the count K with Kmax. If K is greater or equal to Kmax, QBIGGER is called to shift the probability table pointer to a larger Q. The LPS count K is then zeroed and the block counter DLRM reset. The new probability table index is stored in the context state information and LP is updated.

If the current LPS count is within the confidence limits (K < Kmax), the total count measure DLRM is checked to see if it is negative. If so, it is clamped to zero.

The new K value is stored in the context state information as the last step.

L. QBIGGER (Fig. 18):

QBIGGER moves the probability table index to a larger Q. If required, it also interchanges the definitions of LPS and MPS. Since the probability table does not extend beyond Q = 0.5 (the symbols are interchanged instead), there is a discontinuity in the probability adjustment procedure at Q = 0.5. This discontinuity is approximately compensated for by saving the unused table index increment in INCRSV and using it (in SWITCHMPS) to adjust the index to a smaller Q after the MPS-LPS interchange. The test sequence and table pointer adjustment algorithm are described in the previously cited patent application. After adjustment of the index I a new LP value is set.

M. INCRINDEX (Fig. 19):

INCRINDEX shifts the probability table index to a larger Q if possible. If the pointer is already at the top of the table (I = 0), the unused increment is saved for use in SWITCHMPS.

N. DBLINDEX (Fig. 20):

DBLINDEX attempts to adjust the probability table index so as to double the value of Q. If it can not do so, the index change is saved in INCRSV for use in SWITCHMPS.

P. SWITCHMPS (Fig. 21):

SWITCHMPS checks to see if the probability table index is at the top of the table. If so, it is time to interchange the MPS and LPS symbols. The revised definition of the MPS is stored in the context state information, and any unused table adjustment is now added to I to shift the new interchanged Q to a smaller value.

Q. LOGX (Fig. 22):

LOGX calculates log X for use in the decoder. Noting that X is a 20 bit binary fraction, the characteristic is first obtained by shifting X until only the eight most significant bits of X are present. A maximum of 8 bits can be used for the characteristic, as at least 12 bits must be retained in X for it to align properly with the output of the antilog table. If the eight bits (CX) that define the characteristic are all zero, the value of LX is defaulted to hex 2000, a lower limit to the true value. For the conventions used, hex 2000 is equivalent to a characteristic of -8. If CX is not zero, it is converted to the true characteristic by a lookup table (chartbl in the function 'maketbls' in Appendix 1). After the shift by CT, the X value has 13 bits, but the leading bit is always 1 and is truncated by the 'AND' with hex FFF. This provides the address to logtbl (see 'maketbls') where the log of X is tabulated. The output of the log table is subtracted from the characteristic of X, properly shifted to conform to the conventions used for the logs.

R. RENORM -- for the log decoder (Fig. 23):

If the LR value is hex 2000 or larger, renormalization is required before an LPS symbol can be decoded. RENORM is also called when LRM gets too large to fit in 15 bits. RENORM's first task is to check for the hex FFFF pattern in the code stream. If the previous two bytes read from the buffer (B and BO) were both hex FF, the next byte will contain only a possible carry which must be read and added to the present value of X. After this special situation is taken care of, X is shifted by 8 bits and the next byte read and added in. Each time a non-carry byte is read from the code stream, LR is decremented by hex 2000, the change in the characteristic required for an 8 bit shift in X and R. This process is repeated until the integer part of LR is less than 8. After renormalization, a new value of LX is obtained in the call to LOGX.

S. BYTEIN (Fig. 24):

Each time a byte is read from the code stream buffer the pointer BP is first incremented and a check made to see if it is at the end of the buffer (BE). If so, the final byte in the buffer BO is moved to the byte just preceding the start of the buffer BA in order to preserve any possible hex FFFF patterns. Then a new buffer is obtained before returning with the pointer at the byte to be read.

T. UPDATELRT (Fig. 25):

LRT is the parameter required in the comparison with LR in the decoder. The test has two functions: first to detect the occurrence of an LPS, and second to see if the current block count is at the point where a probability update may be required. LX is the measure for the first test, LRM for the second. LRT is always set to the smaller of the two.

U. LRMBIG (Fig. 26):

This code makes sure that LR does not overflow a 15 bit range. If LRM (which is always greater or equal to LR) exceeds hex 7FFF, the 16th bit has been set and renormalization is required. Note that DLRM, the symbol count in the current block, is saved before renormalization so that the probability adaptation is not disturbed.

V. XCARRY (Fig. 27):

XCARRY checks to see if the latest addition to X in the encoder has caused a carry. If so, the carry is propagated to the last byte written into the code stream buffer. That byte is checked for overflow, and any hex FFFF pattern that might have been created is also handled. This technique has been described in a co-pending patent application to J.L. Mitchell and G. Goertzel entitled, "Symmetrical Adaptive Data Compression/Decompression System" which is incorporated into this application by reference to the extent, if any, required to fully disclose the present invention.

W. BUFOUT (Fig. 28):

BUFOUT has the task of transmitting a complete buffer and moving the last three bytes written to the buffer back to the beginning of the buffer. Depending on the circumstances, the bytes moved may or may not be part of the next buffer, but may be required for CHECKFFFF and XCARRY.

X. INITENC (Fig. 29):

INITENC does the initialization for the encoder. It first sets up the tables required, such as the state tables and the various log, antilog and probability tables. It points the state pointer at a dummy state so that a call to CHANGESTATE is forced when the first symbol is encoded. It sets the length of the buffer for the code stream to 256 bytes (an arbitrary but convenient choice), and initializes the pointer to that buffer to 3 bytes before the actual start of the buffer to be sent. The initialization conditions create two dummy bytes of data that are not required to be sent. The pointer is updated before a byte is written; hence an offset of 3 at initialization is needed. Zeroing X zeros both the 20 fractional bits and the 12 integer bits, creating 12 bits in the code stream which are guaranteed to be zero. LR should, in principle, be initialized to 1, giving a range slightly smaller than 1. However, by initializing to hex 1001, an extra 4 bit shift of X is forced, creating exactly two bytes of zeros. These become history for the carry propagation code, but are never sent. The pointer BE is set to point two bytes beyond the last byte in the actual buffer being sent. Note the CHECKFFFF may move the buffer pointer beyond this point before the contents of the buffer are actually sent. Note that setting LRM to LR is not necessary. The CHANGESTATE call overrides this and initializes LRM with LR + DLRST(I). Currently, the initialization of all context states is to IST(S) = 0, MPSST(S) = 0, KST(S) = 0, and DLRST(S) = NMAXLP(0). Thus, all states start a new block with P = 0.5 and MPS = 0.

Y. INITDEC (Fig. 30):

INITDEC does the initialization for the decoder. All states are initialized as in the encoder. Note that again a call to CHANGESTATE is forced. The initialization of X is from the buffer of compressed data. It is noted, however, that LR is initialized to match to the encoder. This forces the extra 4 bit shift required to match the shift in the encoder. LX is calculated by LOGX from the actual code stream data. If the initial two bytes happen to create the hex FFFF pattern, the next zero byte must be skipped.

Z. FLUSH (Fig. 31):

FLUSH is called after the last symbol has been encoded to 'flush' out any residual compressed data from X. By calling RENORM all but the last 4 bytes are sent. Those 4 bytes are forced out by adding hex 8000 to LR and calling RENORM again. Then any buffers or partial buffers remaining must be sent.

V. Test of the Log Coder.

Tests of the present encoder and decoder have included tests on large image data files of both grayscale and facsimile data. The results show that the encoder and decoder are running without error, and that performance is slightly better (less than 1% better) than the arithmetic coder described in the Mitchell-Goertzel European patent application 86115453.2 referenced hereinabove. It should be noted, however, that no attempt was made to initialize the log coder to the expected skew as was done in the coder described in the Mitchell-Goertzel patent application referenced hereinabove. According to the test performed, a grayscale encoder according to the present invention produces context states with remarkably stable and well behaved statistical distributions.

The Log Encoder/Decoder system is designed for implementation on both 16 and 32 bit processors. As noted hereinabove, the operations are structured to make the computational effort scale with the output of compressed data. When working with large probability skews in a single context state, the encoding process reduces essentially to a single 16 bit addition, a test for the type of symbol encountered, and a test for overflow of the allowed range. At the same time, coding efficiency is not sacrificed. Unless the skews are very large (and very little coded data is being generated) the coding efficiency is within 0.2% of the entropy limit, given a correctly specified probability.

VI. Alternative Embodiments

While the invention has been described with reference to preferred embodiments thereof, it will be understood by those skilled in the art that various changes in form and details may be made.

For example, as suggested hereinabove, the described embodiment includes probability adaptation. That is, as data is processed, the probabilities are adjusted in response thereto. A number of the functions detailed hereinabove relate to this feature. The present invention may however also be practiced without probability adaptation --wherein probabilities do not adapt based on prior inputs-- in which event an artisan of ordinary skill may readily omit or alter the operations as appropriate.

Moreover, although described in the context of a grayscale application and a general facsimile application, the teachings of the present invention extend also to other environments in which the product of probabilities are required. Such environments include, but are not limited to, weather calculations, language applications (such as speech recognition), and other problems that may characterized in a probabilistic manner. The result of reducing computational requirements by converting to and computing in the log domain has general use and is intended to have broad scope of application.

It is further noted that, although set forth with a binary arithmetic coding preferred embodiment, the present invention may also be applied to environments in which more than two outcomes (or answers) may result from a decision. In such a case, the multisymbol outcome may be represented as a group of binary decisions or some alternative approach employing the teachings of the invention may be implemented.

It is also observed that the logarithmic domain set forth hereinabove is preferably the base-2 logarithmic domain, although some of the logarithms may be taken in other bases. In this regard, base-2 logarithms are notated by $\log_2$ or log2.

It is further noted that the number line may be ordered with the P-related values at the lower end or with the Q-related values at the lower end in accordance with the invention.

## Claims

**1.** A method of automatically producing look-up tables of logarithms and antilogarithms for use in a machine-implemented arithmetic coding method for encoding a set of binary decisions into a point in range R along a number line and decoding the symbols for a set of decisions from the encoded point wherein at a given step in the coding of a set of decisions P is the probability of the more probable symbol in a subject binary decision and Q is the probability of the less probable symbol in the subject binary decision;

whereby said encoding and decoding comprise steps requiring the computation of logarithms corresponding to the values of P (LP) and P/Q (LPQ) and the antilogarithm of a value (LR) corresponding to the logarithm of the reduced range applicable at the point of encoding or decoding said subject binary decision,
characterised by the steps of
automatically producing an antilog table of outputs having a first predetermined precision corresponding to all mantissa inputs having a second predetermined fixed precision, wherein for any two mantissas $\alpha = \log(A)$ and $\beta = \log(B)$ the following constraint applies:

$\mathrm{antilog}(\alpha + \beta) \leqq \mathrm{antilog}(\alpha) * \mathrm{antilog}(\beta)$; and

wherein each antilog table output is chosen to be unique,
and further automatically producing a table of logarithms of all values of P for that first predetermined fixed precision and corresponding to said antilog table, and reducing said log table by firstly choosing all values of P exhibiting a relative minimum coding inefficiency value, in relation to that first and second predetermined fixed precisions, and secondly eliminating entries which can be replaced by neighbouring entries without increasing coding inefficiency above a predetermined limit.

**2.** The method of Claim 1 wherein the table forming step includes the steps of:
applying the constraint of Claim 1 when $(\alpha + \beta) < 1$ and
applying the constraint

$2 * \mathrm{antilog}\ (\alpha + \beta - 1) \leqq \mathrm{antilog}\ (\alpha) * \mathrm{antilog}\ (\beta)$ when $(\alpha + \beta) \geqq 1$.

**3.** The method of Claims 1 or 2 wherein any entry to be eliminated is replaced by the lower adjacent entry.

**4.** The method of one of the claims 1 to 3 wherein encoded data is in the form of a compressed data stream, the method comprising the further step of:
characterising the compressed data string in terms of bytes each of which represents a plurality of bits; and
inputting and outputting the compressed data stream by bytes.

**Patentansprüche**

**1.** Verfahren zum automatischen Erzeugen von Nachschlagetabellen mit Logarithmen und Antilogarithmen für die Verwendung in einem maschinengestützten arithmetischen Codierverfahren für die Codierung eines Satzes binärer Entscheidungen in einen Punkt im Bereich R auf einer Zahlengeraden und die Decodierung der Symbole für einen Satz von Entscheidungen aus dem codierten Punkt, wobei in einem gegebenen Schritt des Codierens eines Satzes von Entscheidungen P die Wahrscheinlichkeit des wahrscheinlicheren Symbols in einer solchen binären Entscheidung und Q die Wahrscheinlichkeit des weniger wahrscheinlichen Symbols in der binären Entscheidung ist;
wobei das Codieren und Decodieren Schritte umfassen, die die Berechnung von Logarithmen, die den Werten P (LP) und P/Q (LPQ) entsprechen, und des Antilogarithmus eines Wertes (LR), der dem Logarithmus des verringerten Bereichs, der zu dem Zeitpunkt des Codierens bzw. Decodierns der binären Entscheidung gültig ist, entspricht, erfordern,
gekennzeichnet durch folgende Schritte
automatisches Erzeugen einer Tabelle mit Antilogarithmen von Ausgaben mit einer ersten im voraus bestimmten Genauigkeit, die allen Mantissen-Eingaben mit einer zweiten im voraus bestimmten, festen Genauigkeit entsprechen, wobei für zwei beliebige Mantissen $\alpha = \log(A)$ und $\beta = \log(B)$ die folgende Einschränkung gilt:

$\mathrm{antilog}\ (\alpha + \beta) \leqq \mathrm{antilog}(\alpha) * \mathrm{antilog}(\beta)$; und

wobei jede Ausgabe der Tabelle mit den Antilogarithmen als eindeutig gewählt wird,
und ferner automatisches Erzeugen einer Tabelle mit Logarithmen von allen Werten von P für die erste im voraus bestimmte, feste Genauigkeit und entsprechend der Tabelle mit den Antilogarithmen, sowie Reduzieren der Tabelle mit den Logarithmen, indem in Relation zu der ersten und zweiten im voraus bestimmten, festen Genauigkeit erstens alle Werte von P gewählt werden, deren Codierungsineffizienz ein relatives Minimum aufweist, und zweitens Einträge entfernt werden, die durch benachbarte Einträge ersetzt werden können, ohne die Codierungsineffizienz über eine im voraus bestimmte Grenze hinaus zu erhöhen.

**2.** Verfahren gemäß Anspruch 1, wobei der tabellenbildende Schritt folgende Schritte enthält:
Anwenden der Einschränkung gemäß Anspruch 1, wenn $(\alpha + \beta) < 1$ ist, und
Anwenden der Einschränkung

$$2 * \text{antilog}\ (\alpha + \beta - 1) \leqq \text{antilog}\ (\alpha) * \text{antilog}\ (\beta),\ \text{wenn}\ (\alpha + \beta) \geqq 1\ \text{ist.}$$

**3.** Verfahren gemäß Anspruch 1 oder 2, wobei jeder zu entfernende Eintrag durch den niedrigeren, benachbarten Eintrag ersetzt wird.

**4.** Verfahren gemäß einem der Ansprüche 1 bis 3, wobei die codierten Daten in Form eines komprimierten Datenstroms vorliegen und das Verfahren folgende weitere Schritte umfaßt:
bytebezogene Charakterisierung der Zeichenkette mit komprimierten Daten, wobei jedes Byte eine Vielzahl von Bits darstellt; und
byteweise Eingabe und Ausgabe des komprimierten Datenstroms.

## Revendications

**1.** Un procédé de production automatique de tables de consultation de logarithmes et d'anti-logarithmes à utiliser dans un procédé de codage arithmétique mis en oeuvre en machine pour coder un ensemble de décisions binaires en un point du domaine R sur une ligne numérique et pour décoder les symboles pour un ensemble de décisions depuis le point codé, dans lequel, à une étape donnée du codage d'un ensemble de décisions, P est la probabilité du symbole le plus probable dans une décision binaire traitée et Q est la probabilité du symbole le moins probable dans la décision binaire traitée,

ce qui fait que ledit codage et ledit décodage comprennent des étapes requérant le calcul de logarithmes correspondant aux valeurs de P (LP) et P/Q (LPQ) et des anti-logarithmes d'une valeur (LR) correspondant au logarithme du domaine réduit applicable au point de codage ou de décodage de ladite décision binaire traitée,

caractérisé par les étapes de:

- production automatique d'une table anti-logarithmique des sorties ayant une première précision prédéterminée correspondant à toutes les entrées de mantisse ayant une seconde précision fixe prédéterminée, où pour toute paire de mantisses $\alpha = \log(A)$ et $\beta = \log(B)$, la contrainte suivante s'applique:

  $$\text{antilog}(\alpha + \beta) \leqq \text{antilog}(\alpha) * \text{antilog}(\beta),\ \text{et}$$

- où chaque sortie de table anti-logarithmique est choisie pour être caractéristique,
  - et en outre, de production automatique d'une table de logarithmes de toutes les valeurs de P pour cette première précision fixe prédéterminée et correspondant à ladite table anti-logarithmique, et de réduction de ladite table logarithmique en choisissant tout d'abord toutes les valeurs de P présentant une valeur d'inefficacité de codage minimale relative, par rapport à ces première et seconde précisions fixes prédéterminées, et ensuite en éliminant des entrées qui peuvent être remplacées par des entrées voisines sans augmenter l'inefficacité du codage au delà d'une limite prédéterminée.

**2.** Le procédé de la revendication 1 dans lequel l'étape de formation des tables comprend les étapes suivantes:

- l'application de la contrainte de la revendication 1 lorsque $(\alpha + \beta) < 1$ et
- l'application de la contrainte

  $$2 * \text{antilog}\ (\alpha + \beta - 1) < \text{antilog}\ (\alpha) * \text{antilog}\ (\beta)\ \text{lorsque}\ (\alpha + \beta) \geqq 1.$$

**3.** Le procédé des revendications 1 ou 2 dans lequel toute entrée à éliminer est remplacée par l'entrée adjacente inférieure.

**4.** Le procédé selon l'une des revendications 1 à 3 dans lequel des données codées se présentent sous la forme d'un courant de données comprimées, le procédé comprenant l'étape supplémentaire de:

- caractérisation de la chaîne de données comprimées en termes de multiplets qui représentent chacun une pluralité de bits, et de
- entrée et sortie du courant de données comprimées par multiplets.

FIG. 1

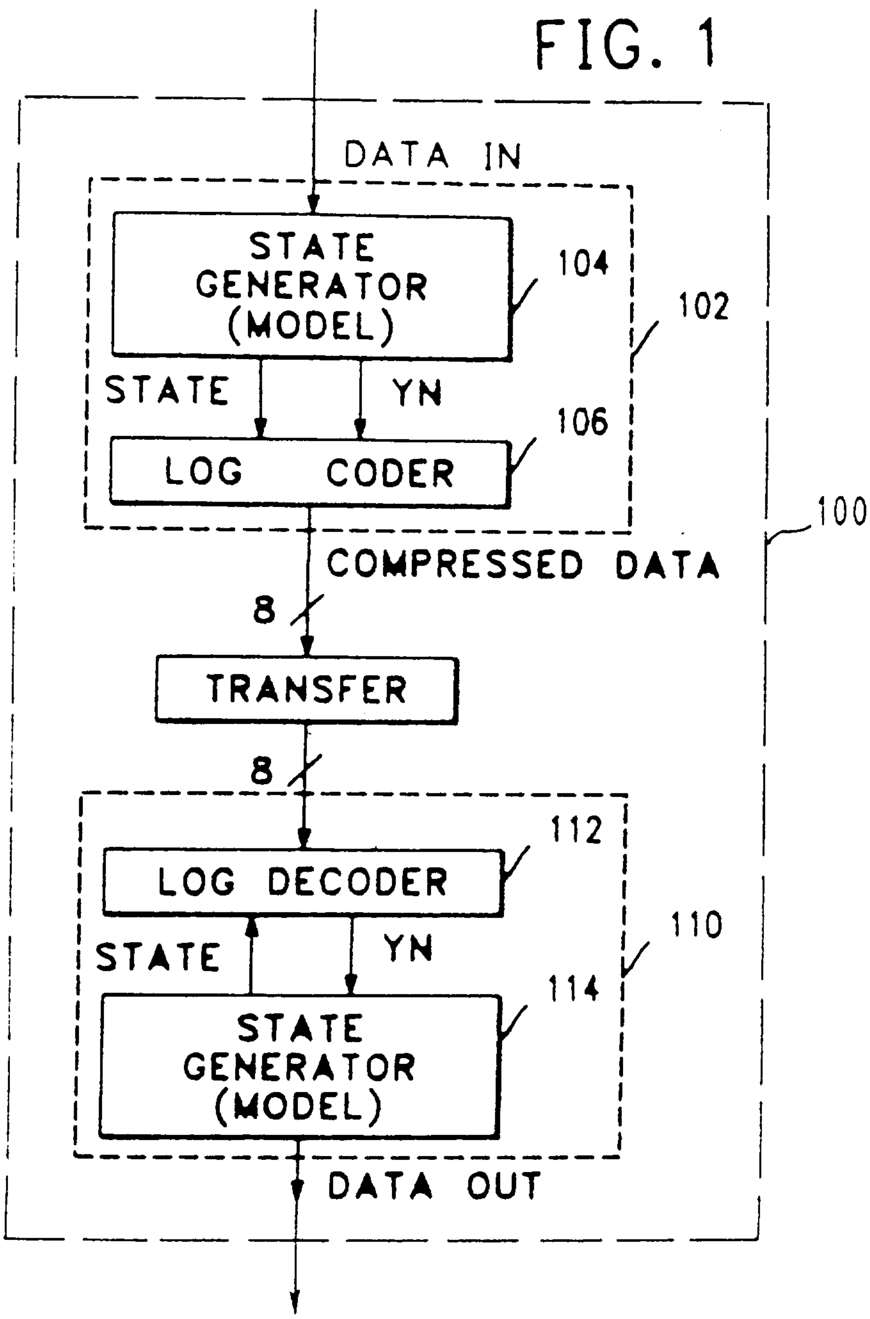
DATA IN
STATE
GENERATOR
(MODEL)
104
102
STATE
YN
106
LOG CODER
100
COMPRESSED DATA
8
TRANSFER
8
112
LOG DECODER
110
STATE
YN
114
STATE
GENERATOR
(MODEL)
DATA OUT

FIG. 2

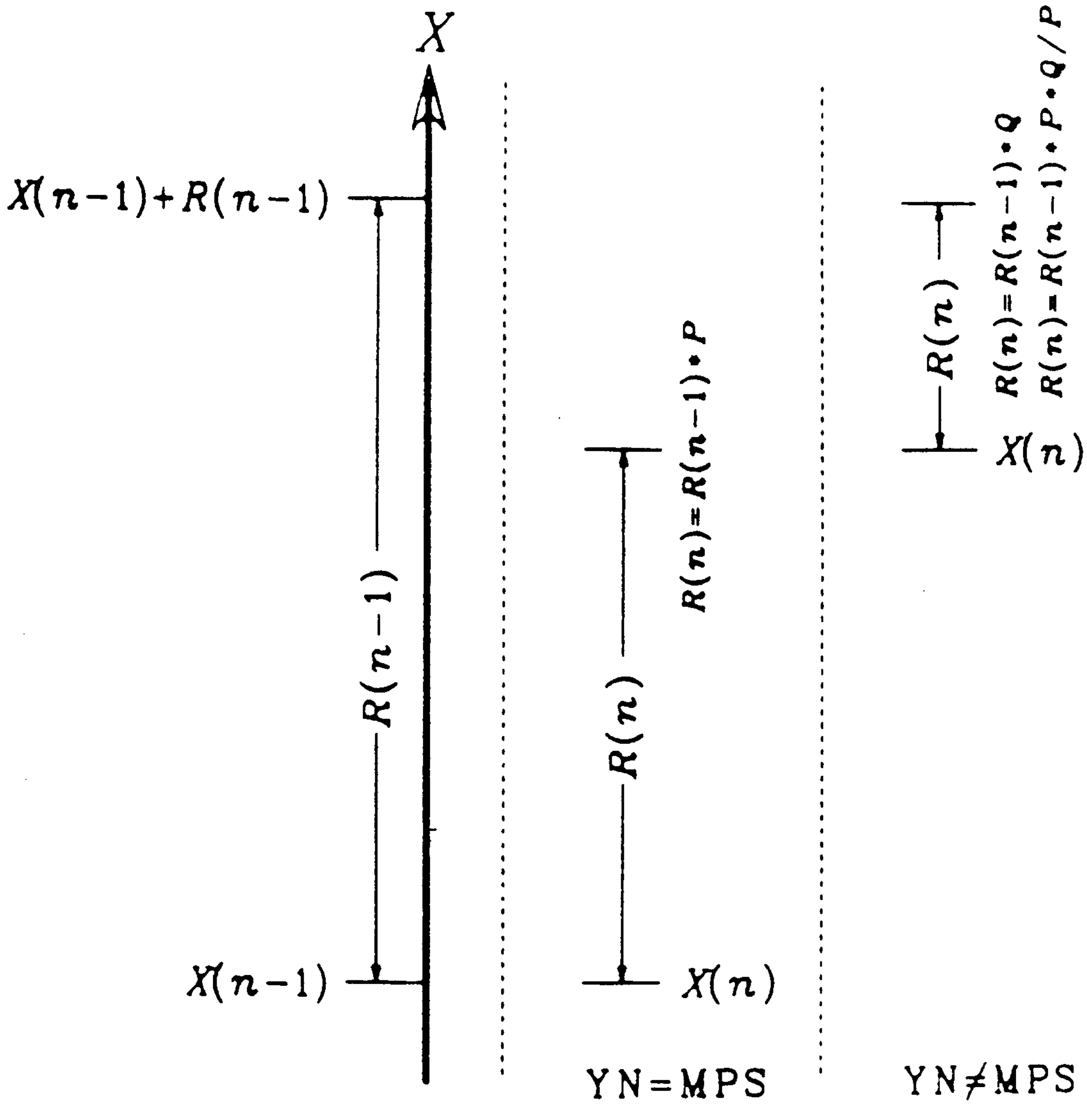
X
X(n-1)+R(n-1)
R(n-1)
X(n-1)
R(n)
R(n)=R(n-1)•P
X(n)
YN=MPS
R(n)
R(n)=R(n-1)•Q
R(n)=R(n-1)•P•Q/P
X(n)
YN≠MPS

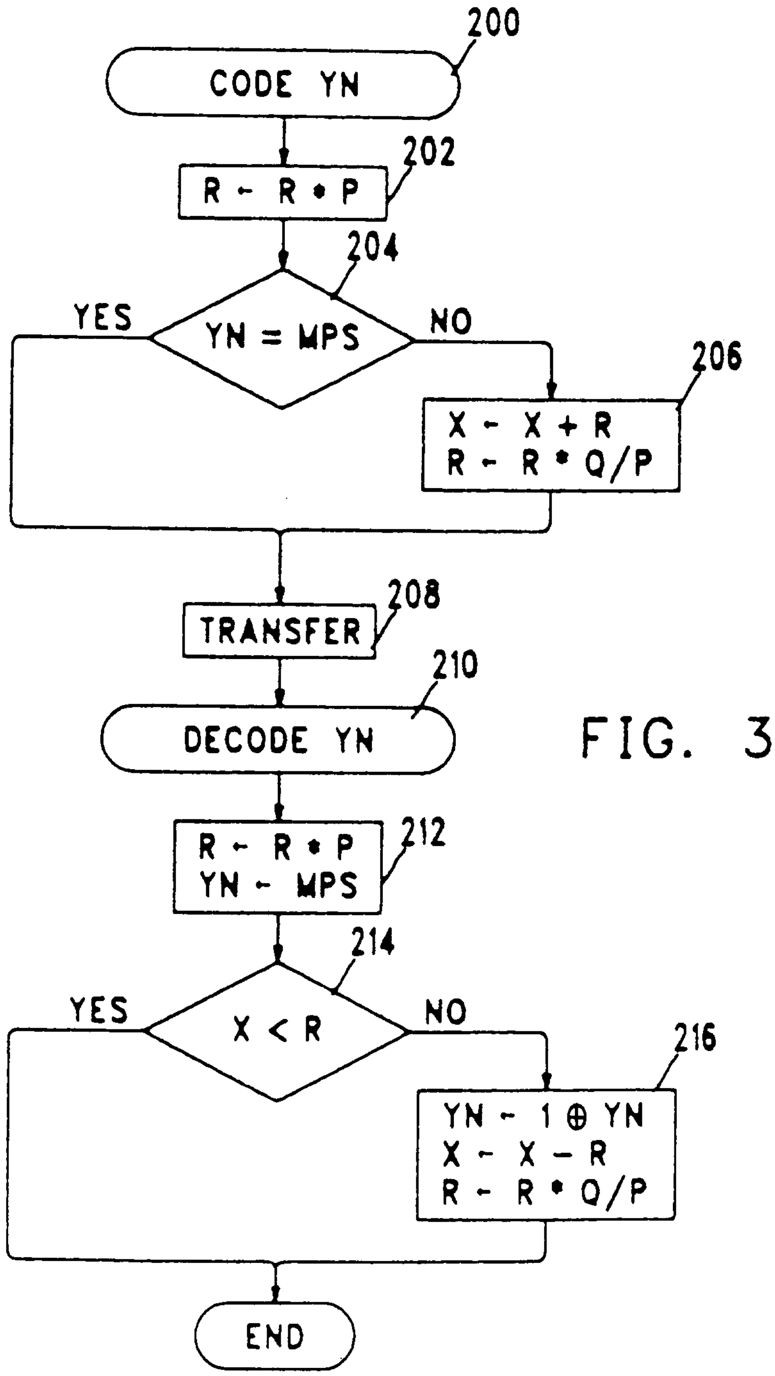
200
CODE YN
202
R ← R * P
204
YES
YN = MPS
NO
206
X ← X + R
R ← R * Q/P
208
TRANSFER
210
DECODE YN
212
R ← R * P
YN ← MPS
214
YES
X < R
NO
216
YN ← 1 ⊕ YN
X ← X − R
R ← R * Q/P
END

FIG. 3

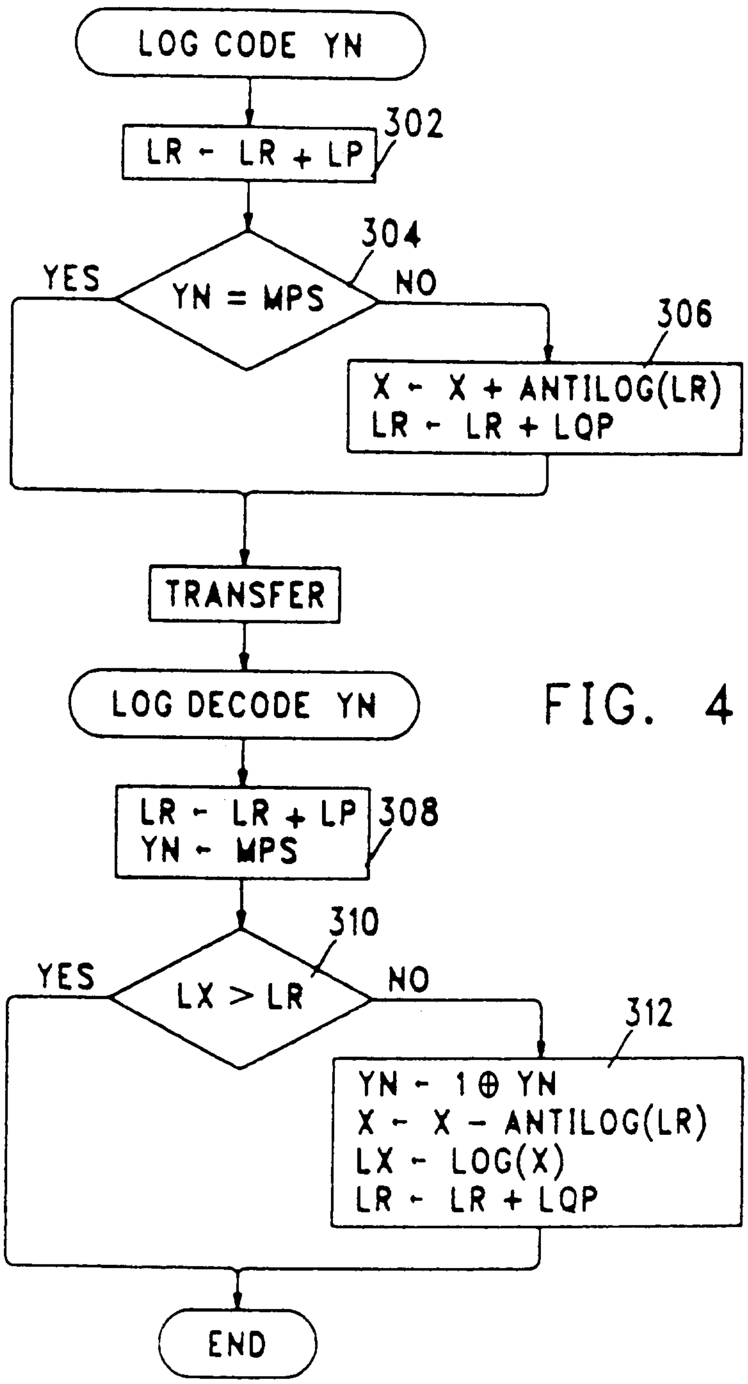
LOG CODE YN
LR ← LR + LP
302
YN = MPS
304
YES
NO
X ← X + ANTILOG(LR)
LR ← LR + LQP
306
TRANSFER
LOG DECODE YN
LR ← LR + LP
YN ← MPS
308
LX > LR
310
YES
NO
YN ← 1 ⊕ YN
X ← X − ANTILOG(LR)
LX ← LOG(X)
LR ← LR + LQP
312
END

FIG. 4

FIG. 5

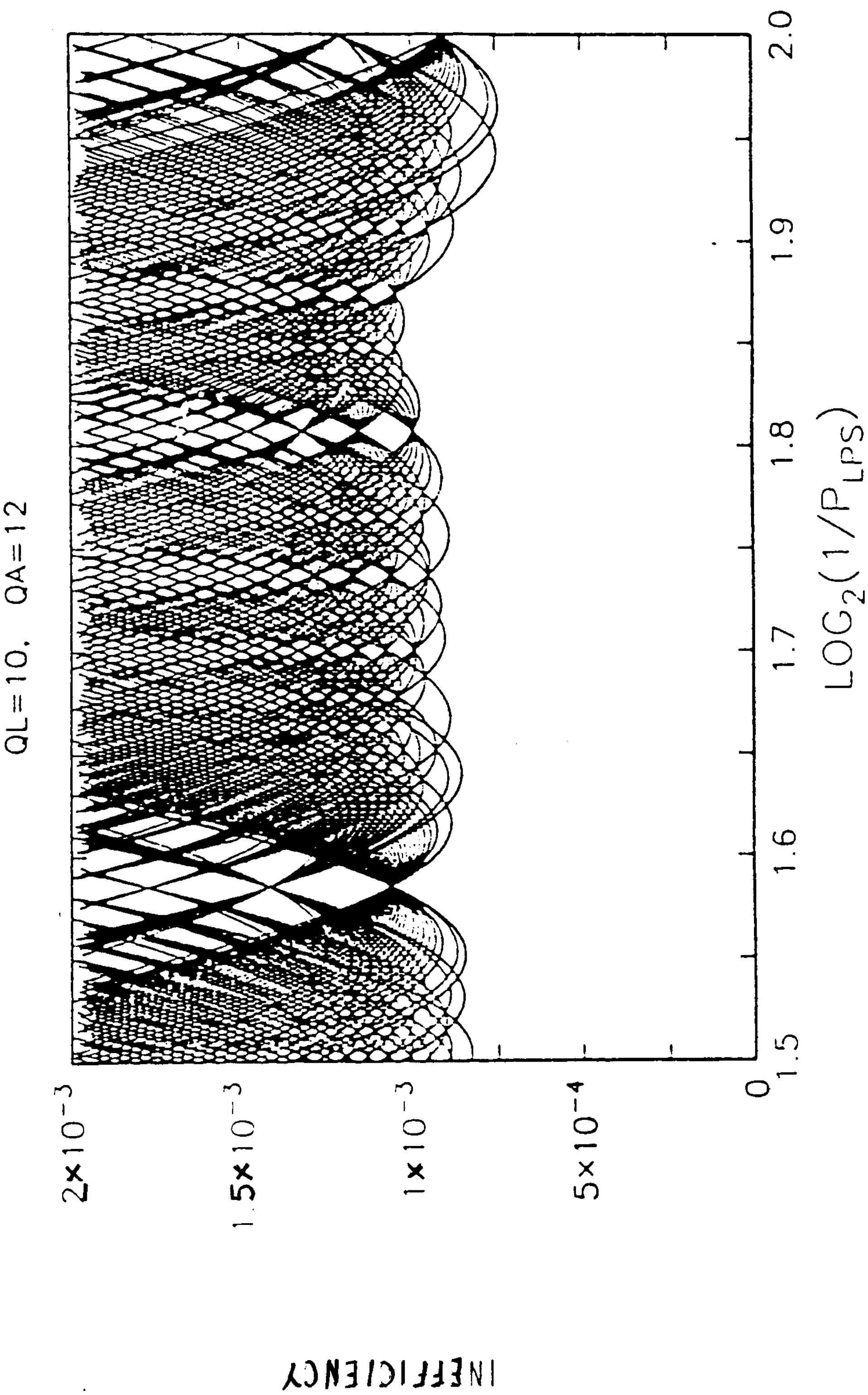

QL=10, QA=12
2×10⁻³
1.5×10⁻³
1×10⁻³
5×10⁻⁴
0
1.5
1.6
1.7
1.8
1.9
2.0
$LOG_2(1/P_{LPS})$
INEFFICIENCY

FIG. 6

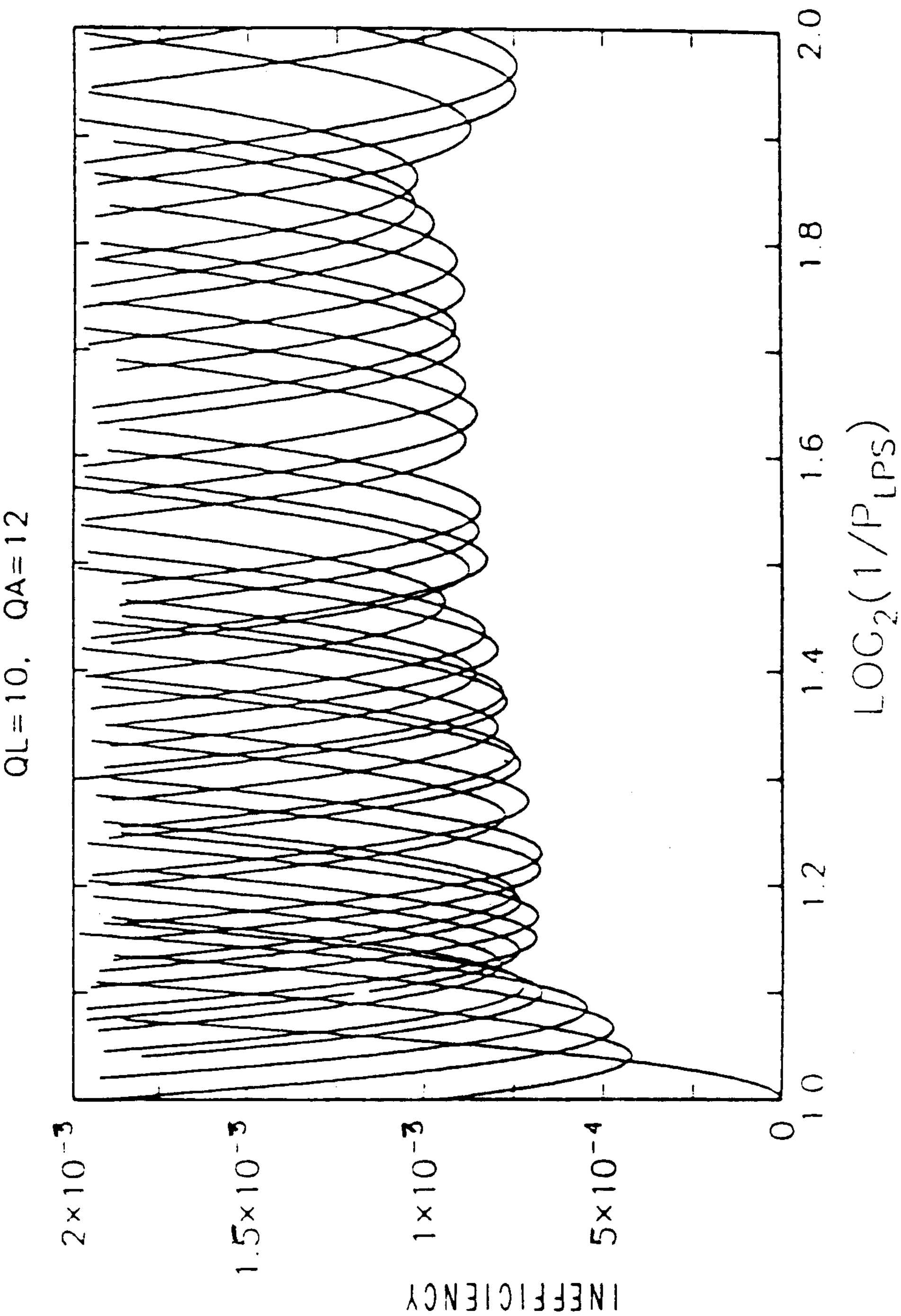
QL=10, QA=12
INEFFICIENCY
2×10⁻³
1.5×10⁻³
1×10⁻³
5×10⁻⁴
0
1.0
1.2
1.4
1.6
1.8
2.0
LOG₂(1/P_LPS)

FIG. 7

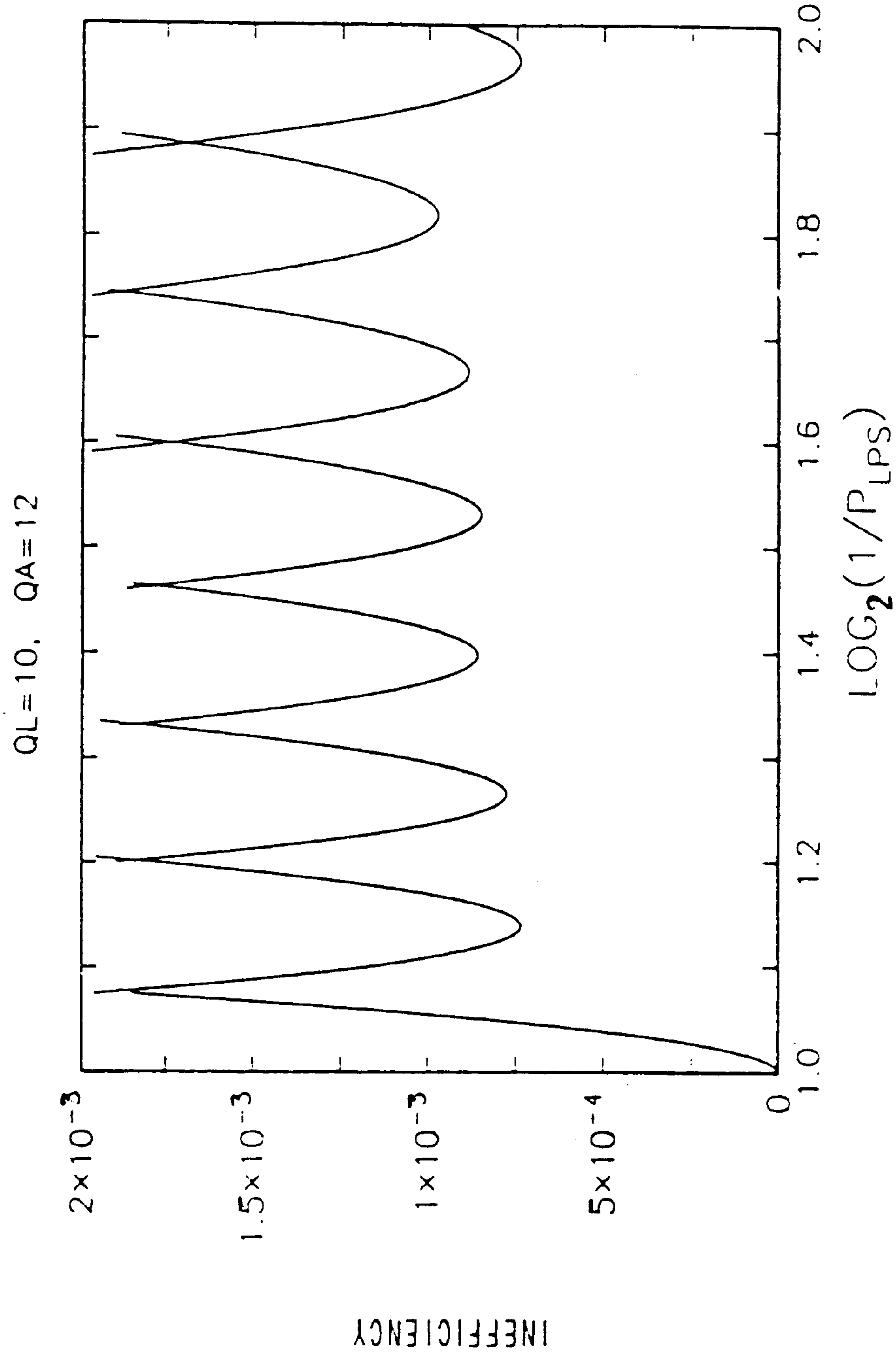
QL=10, QA=12
INEFFICIENCY
2×10⁻³
1.5×10⁻³
1×10⁻³
5×10⁻⁴
0
1.0
1.2
1.4
1.6
1.8
2.0
LOG2(1/PLPS)

FIG. 8

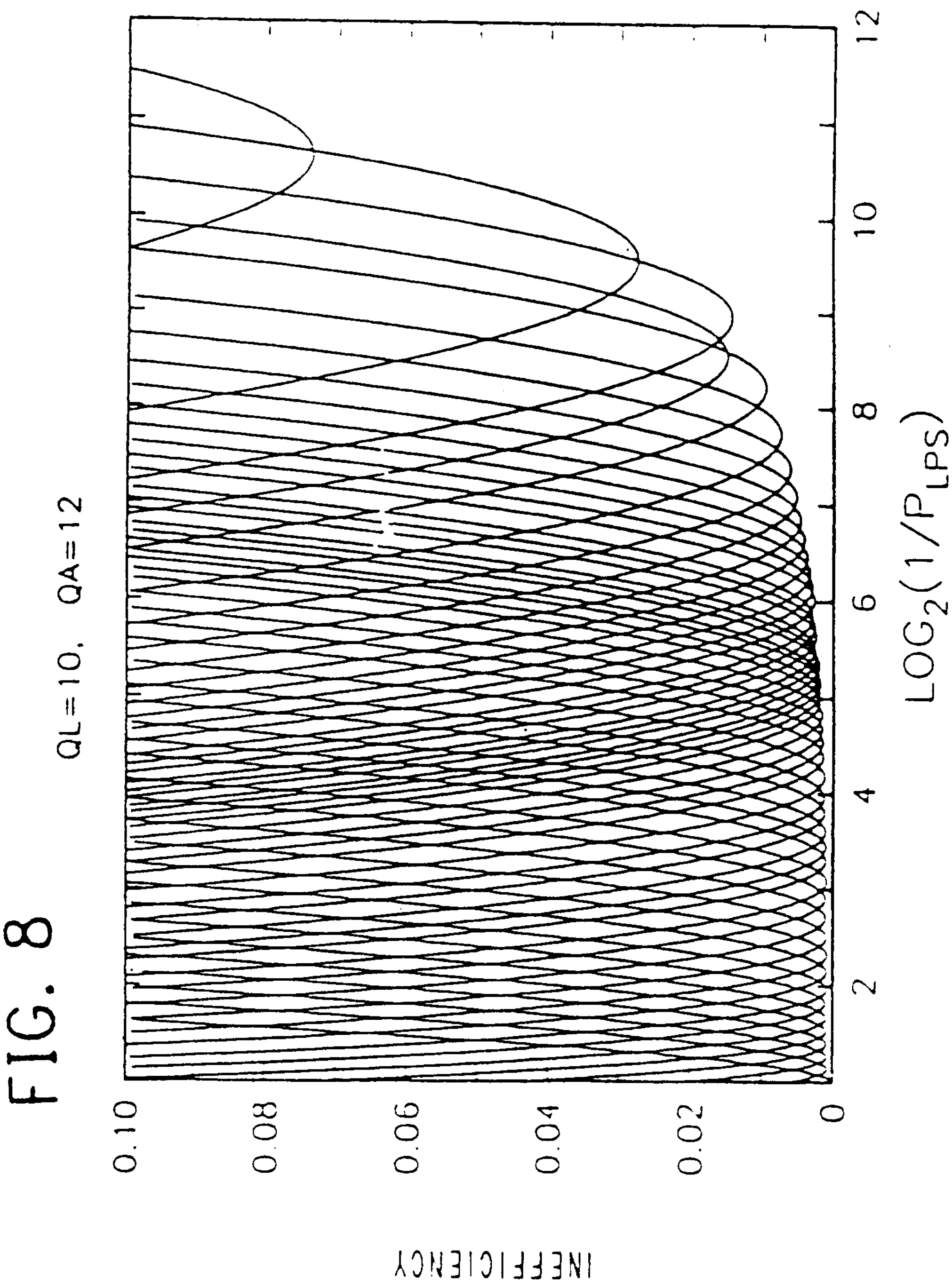

QL=10, QA=12
INEFFICIENCY
0.10
0.08
0.06
0.04
0.02
0
2
4
6
8
10
12
LOG2(1/PLPS)

FIG.9

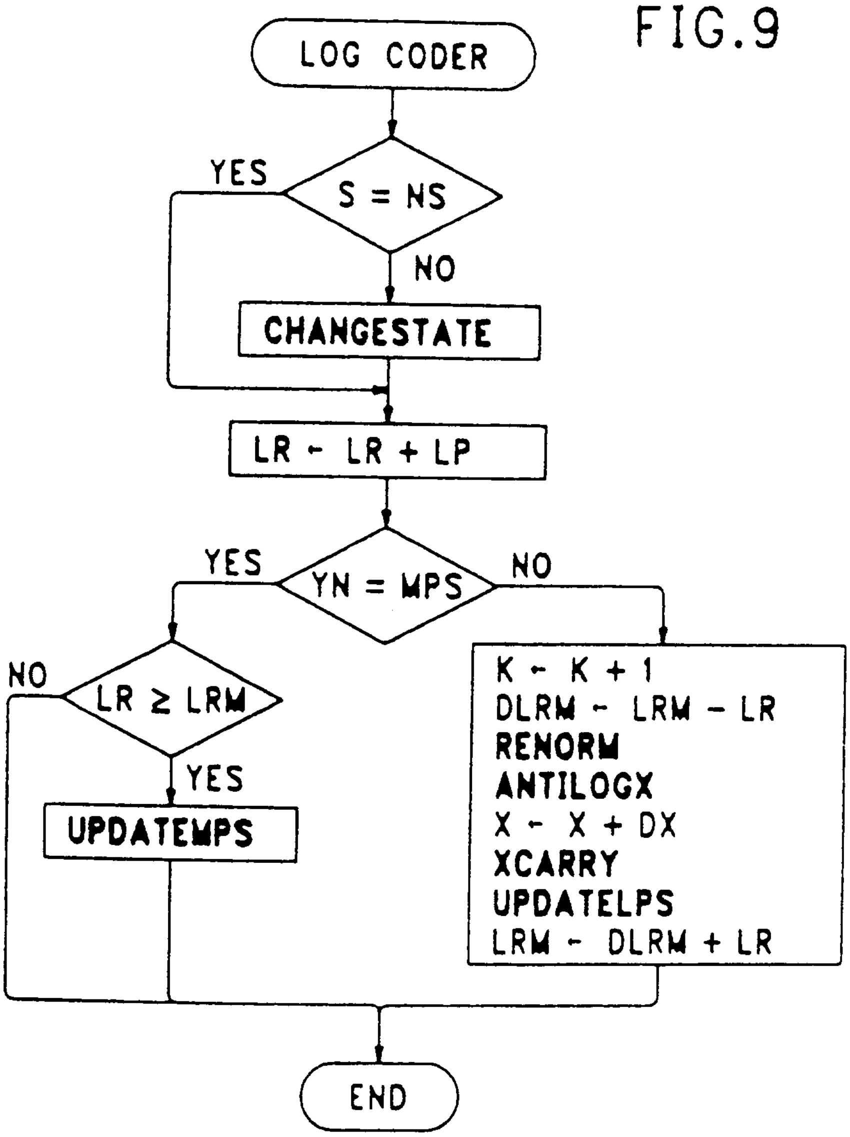
LOG CODER
S = NS
YES
NO
CHANGESTATE
LR ← LR + LP
YN = MPS
YES
NO
LR ≥ LRM
NO
YES
UPDATEMPS
K ← K + 1
DLRM ← LRM − LR
RENORM
ANTILOGX
X ← X + DX
XCARRY
UPDATELPS
LRM ← DLRM + LR
END

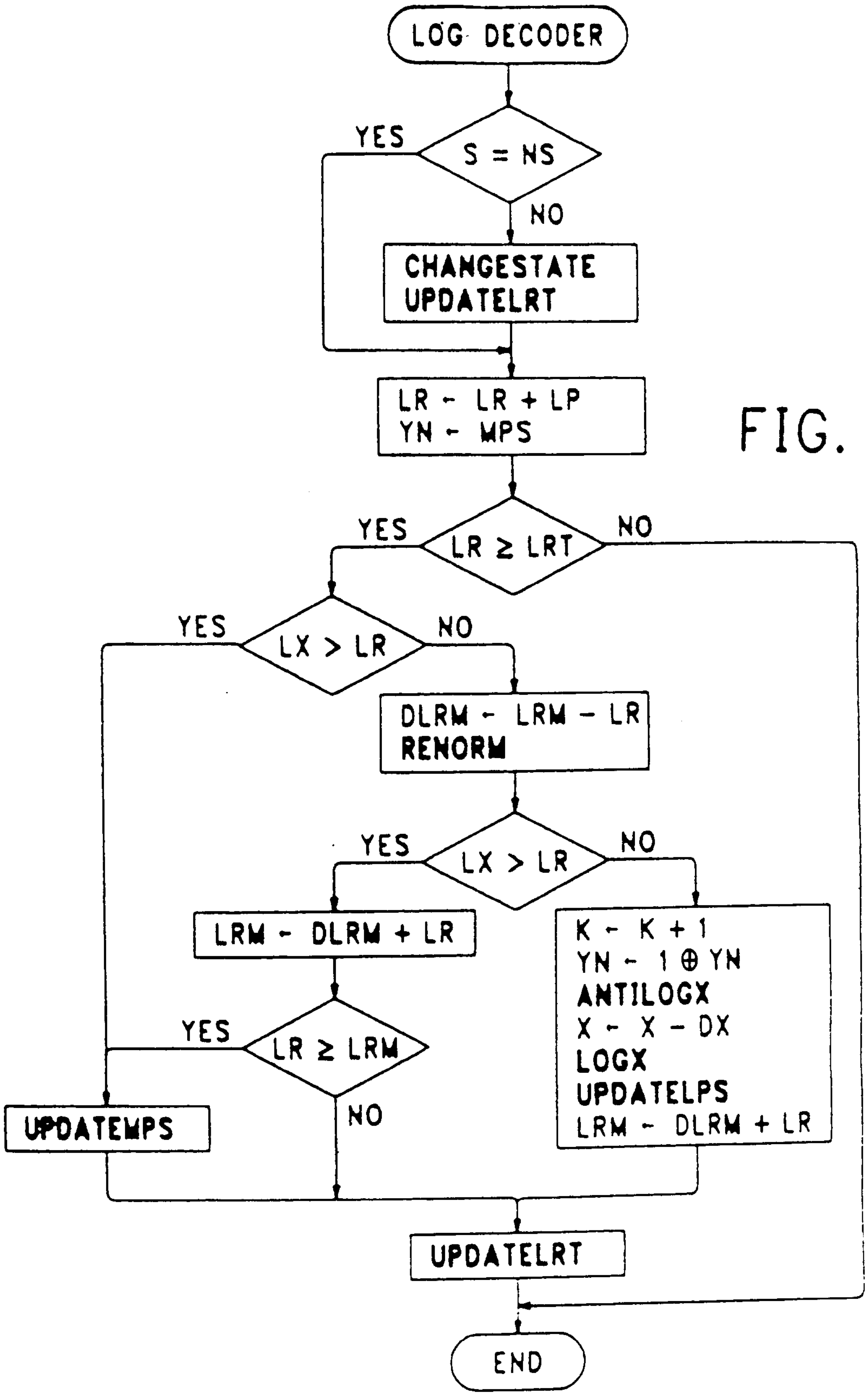
LOG DECODER
S = NS
YES
NO
CHANGESTATE
UPDATELRT
LR ← LR + LP
YN ← MPS
LR ≥ LRT
YES
NO
LX > LR
YES
NO
DLRM ← LRM − LR
RENORM
LX > LR
YES
NO
LRM ← DLRM + LR
K ← K + 1
YN ← 1 ⊕ YN
ANTILOGX
X ← X − DX
LOGX
UPDATELPS
LRM ← DLRM + LR
LR ≥ LRM
YES
NO
UPDATEMPS
UPDATELRT
END

FIG. 10

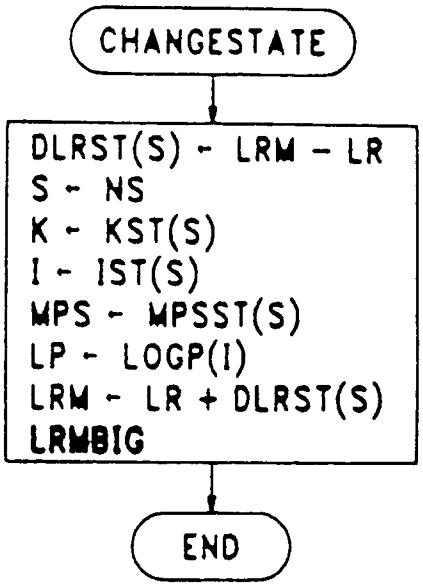
CHANGESTATE
DLRST(S) ← LRM − LR
S ← NS
K ← KST(S)
I ← IST(S)
MPS ← MPSST(S)
LP ← LOGP(I)
LRM ← LR + DLRST(S)
LRMBIG
END

FIG. 11

FIG. 12

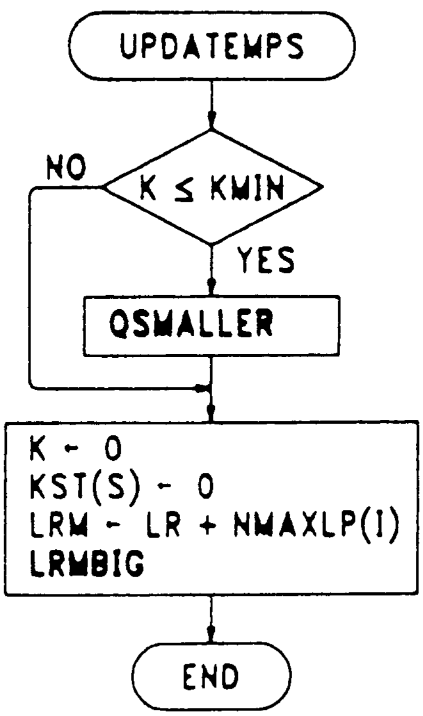
UPDATEMPS
NO
K ≤ KMIN
YES
QSMALLER
K ← 0
KST(S) ← 0
LRM ← LR + NMAXLP(I)
LRMBIG
END

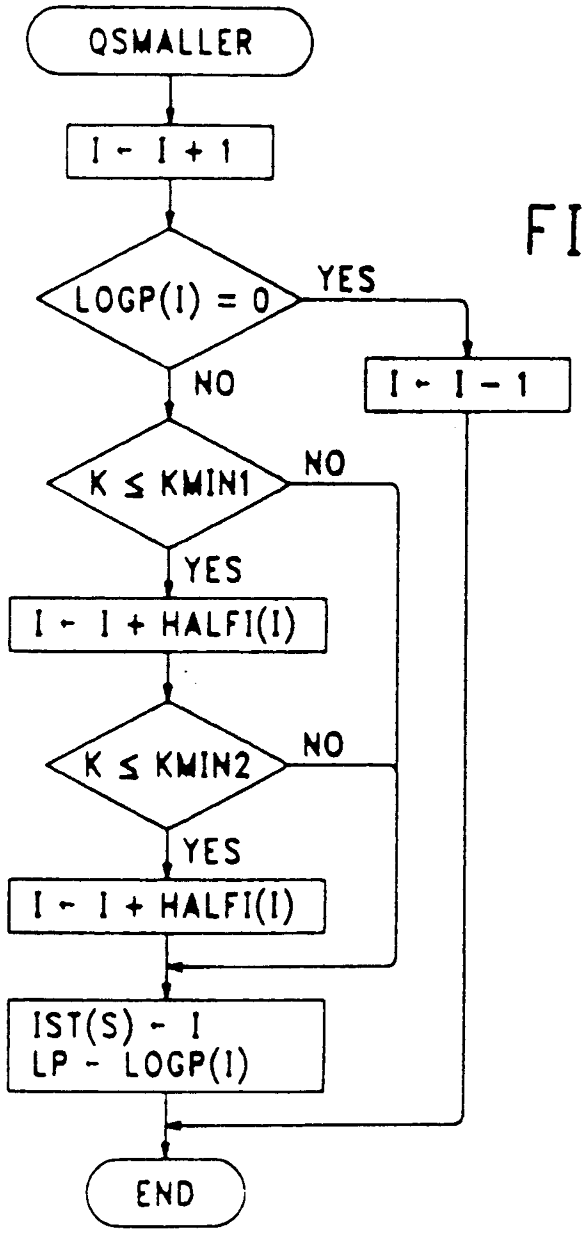
QSMALLER
I ← I + 1
LOGP(I) = 0
YES
I ← I − 1
NO
K ≤ KMIN1
NO
YES
I ← I + HALFI(I)
K ≤ KMIN2
NO
YES
I ← I + HALFI(I)
IST(S) ← I
LP ← LOGP(I)
END

FIG. 13

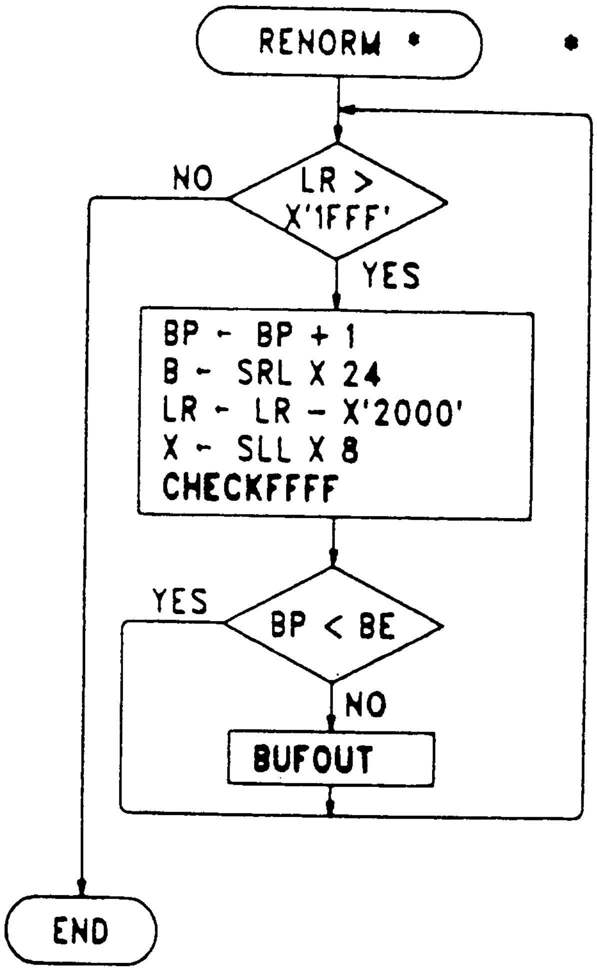


* FOR LOG CODER

FIG. 14

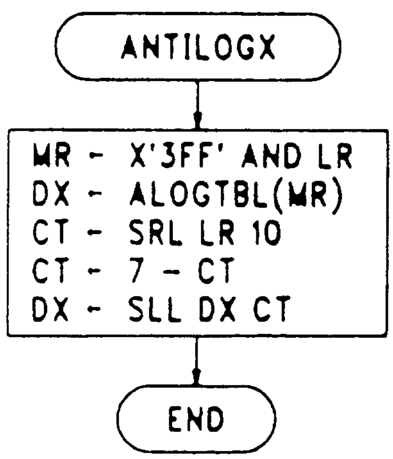


FIG. 15

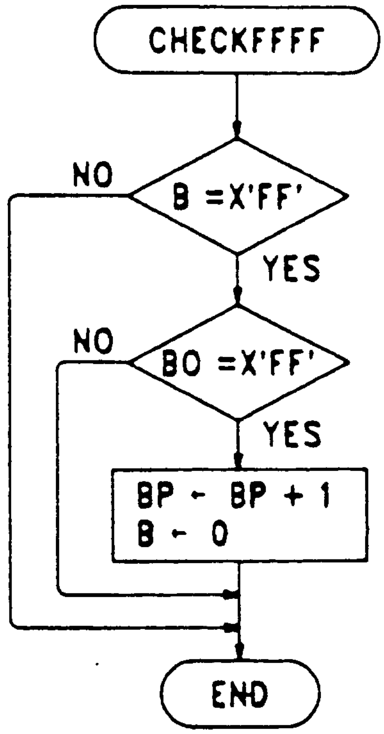
CHECKFFFF
B =X'FF'
NO
YES
BO =X'FF'
NO
YES
BP ← BP + 1
B ← 0
END

FIG. 16

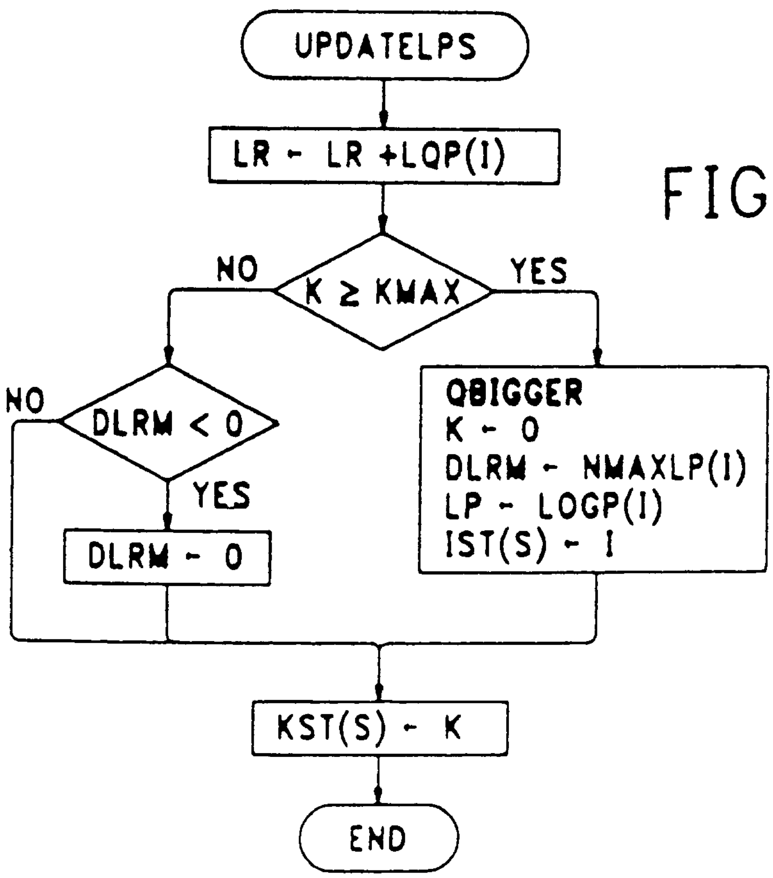
UPDATELPS
LR ← LR +LQP(I)
K ≥ KMAX
NO
YES
DLRM < 0
NO
YES
DLRM ← 0
QBIGGER
K ← 0
DLRM ← NMAXLP(I)
LP ← LOGP(I)
IST(S) ← I
KST(S) ← K
END

FIG. 17

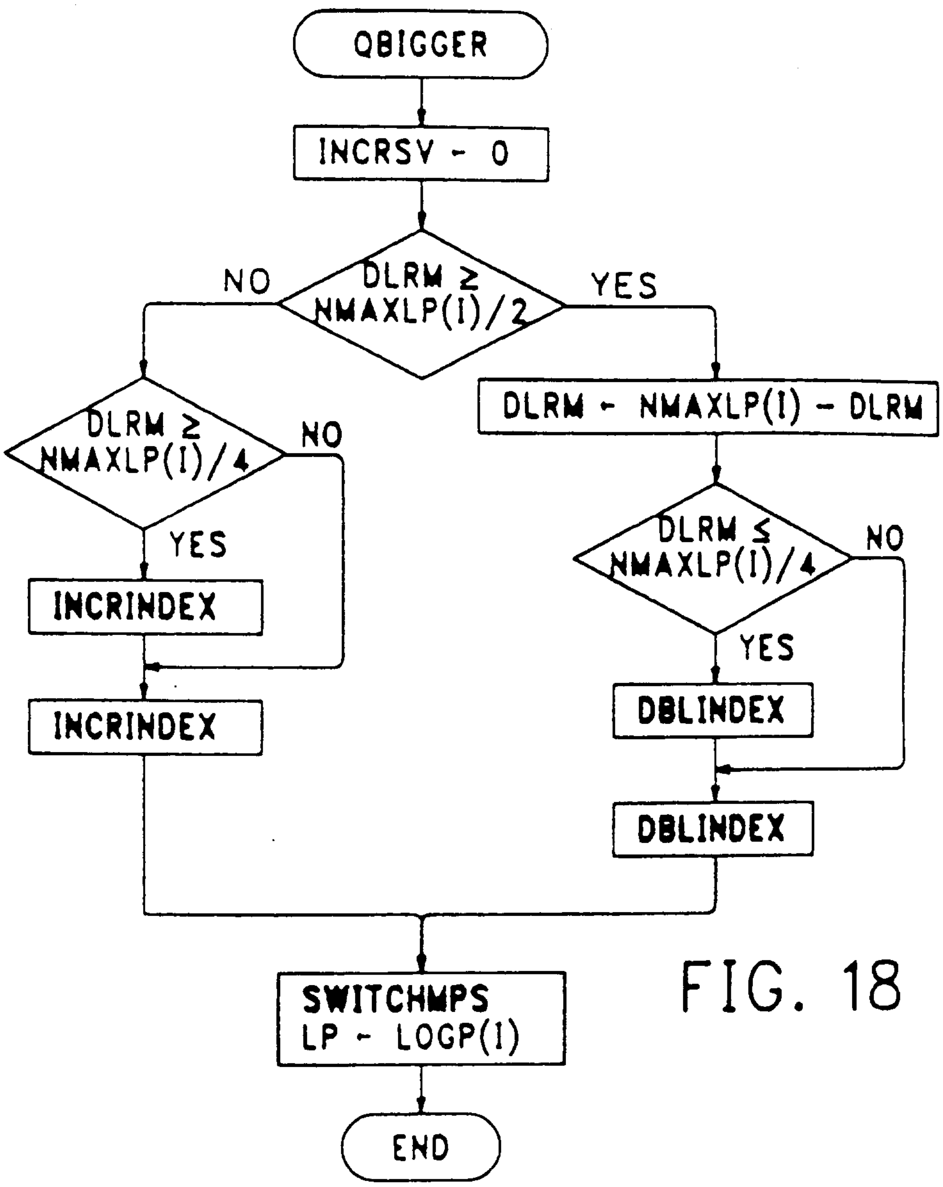
QBIGGER
INCRSV ← 0
DLRM ≥ NMAXLP(I)/2
NO
YES
DLRM ≥ NMAXLP(I)/4
NO
YES
INCRINDEX
INCRINDEX
DLRM ← NMAXLP(I) − DLRM
DLRM ≤ NMAXLP(I)/4
NO
YES
DBLINDEX
DBLINDEX
SWITCHMPS
LP ← LOGP(I)
END

FIG. 18

FIG. 19

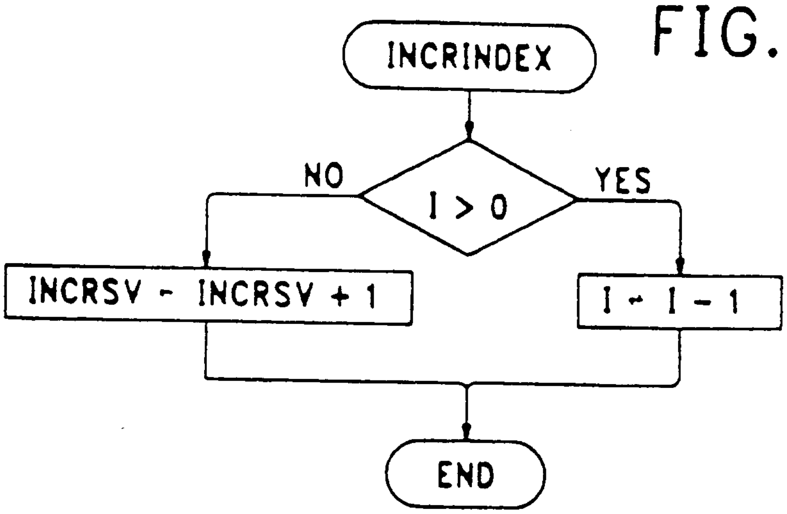
INCRINDEX
NO
I > 0
YES
INCRSV - INCRSV + 1
I - I - 1
END

FIG. 20

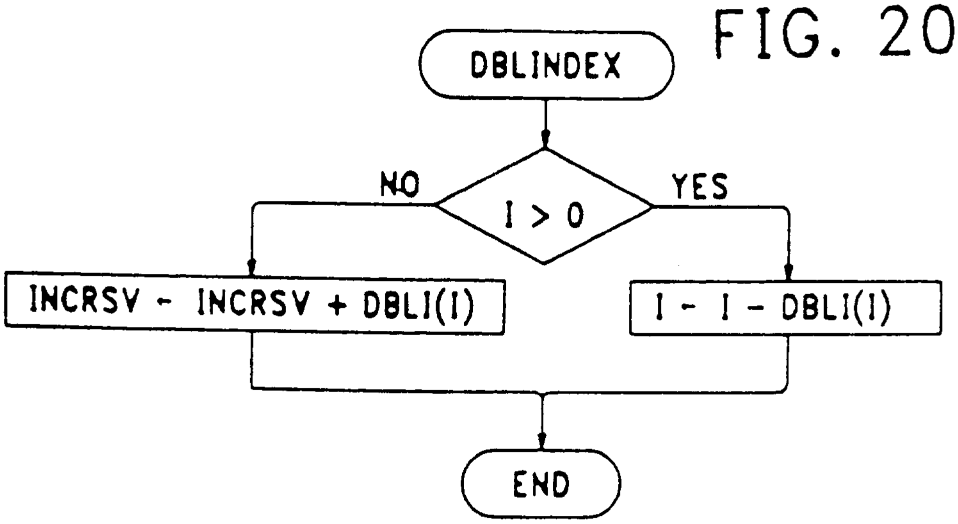
DBLINDEX
NO
I > 0
YES
INCRSV - INCRSV + DBLI(I)
I - I - DBLI(I)
END

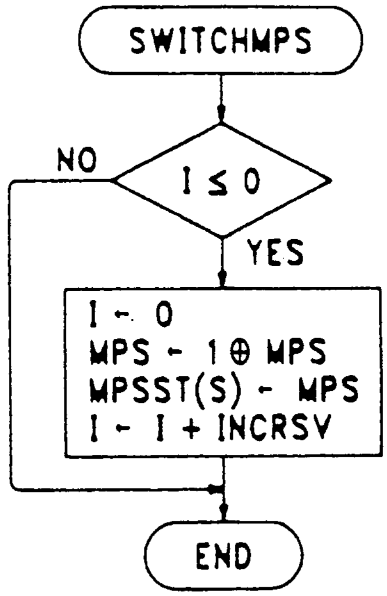
SWITCHMPS
I ≤ 0
NO
YES
I ← 0
MPS ← 1 ⊕ MPS
MPSST(S) ← MPS
I ← I + INCRSV
END

FIG. 21

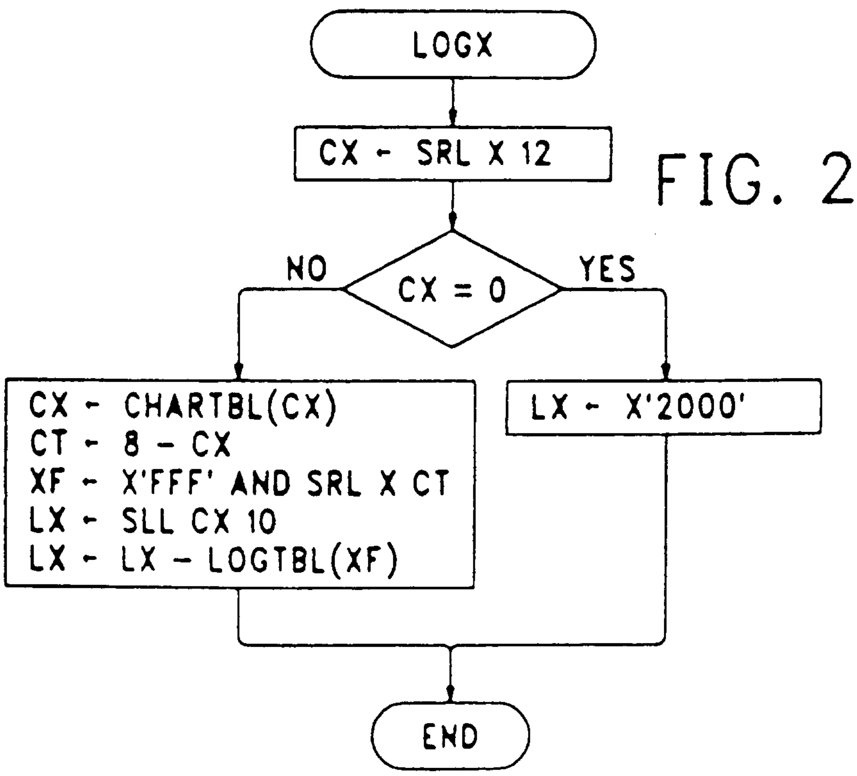
LOGX
CX ← SRL X 12
CX = 0
NO
YES
CX ← CHARTBL(CX)
CT ← 8 – CX
XF ← X'FFF' AND SRL X CT
LX ← SLL CX 10
LX ← LX – LOGTBL(XF)
LX ← X'2000'
END

FIG. 22

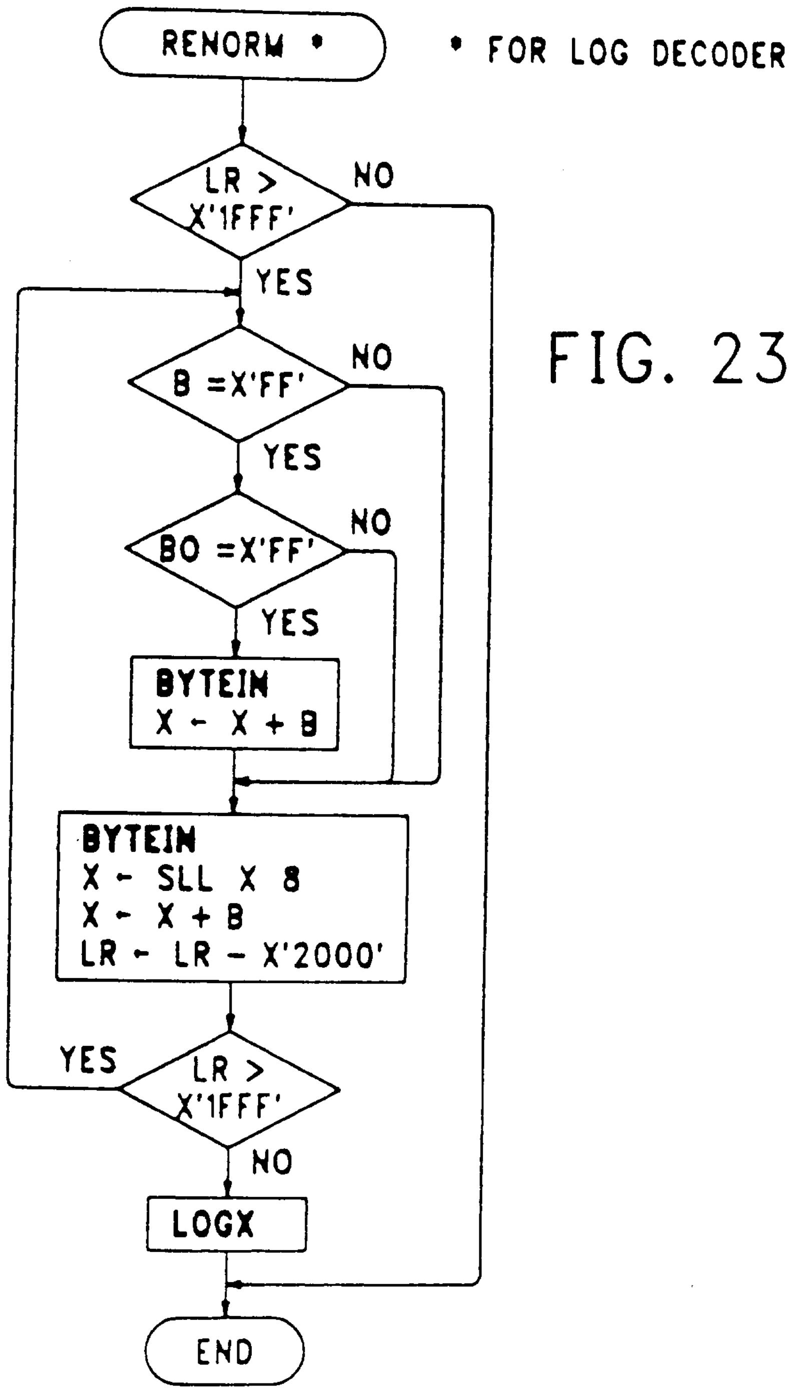
RENORM *
* FOR LOG DECODER
LR > X'1FFF'
NO
YES
B =X'FF'
NO
YES
BO =X'FF'
NO
YES
BYTEIN
X ← X + B
BYTEIN
X ← SLL X 8
X ← X + B
LR ← LR − X'2000'
YES
LR > X'1FFF'
NO
LOGX
END

FIG. 23

FIG. 24

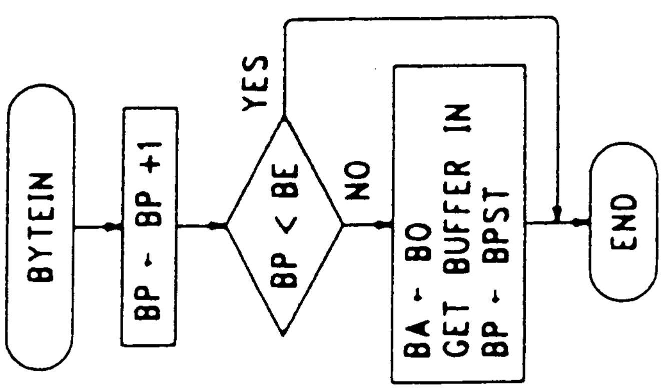


FIG. 25

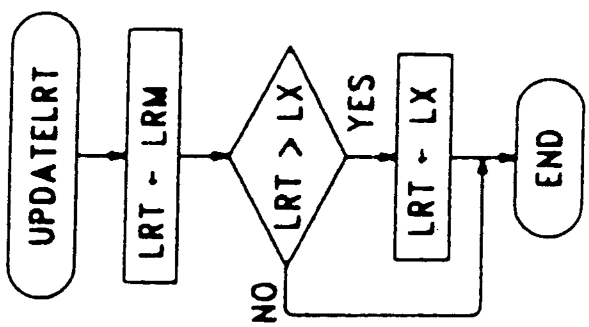


FIG. 26

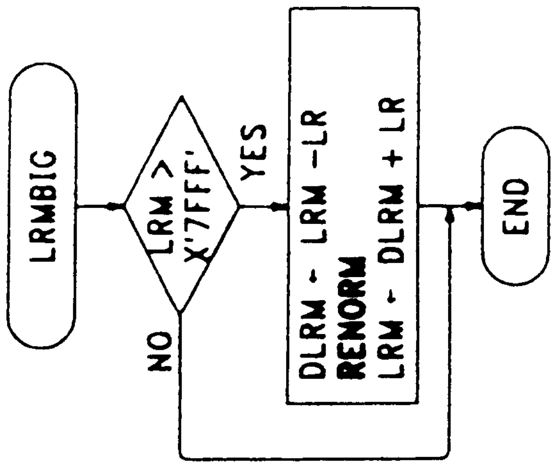

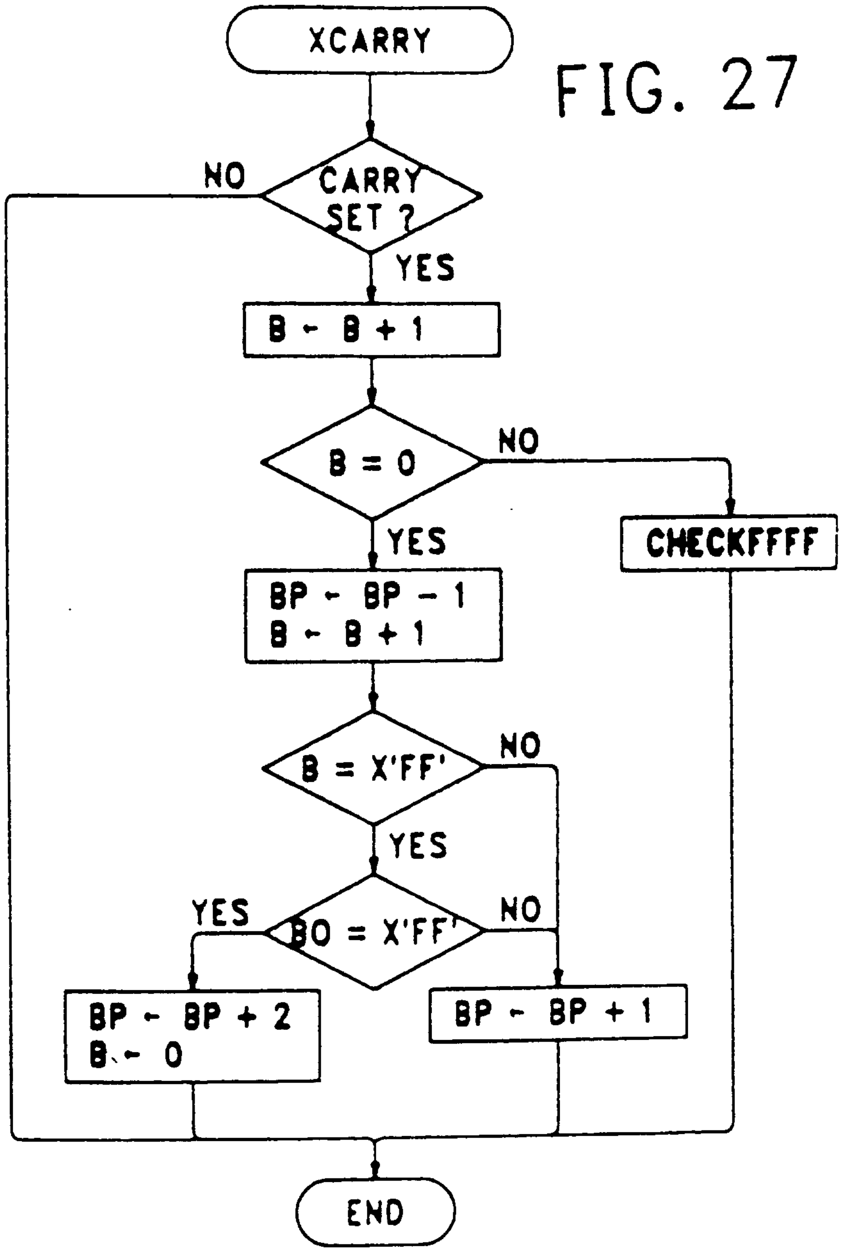
XCARRY
CARRY SET ?
NO
YES
B ← B + 1
B = 0
NO
YES
CHECKFFFF
BP ← BP − 1
B ← B + 1
B = X'FF'
NO
YES
BO = X'FF'
YES
NO
BP ← BP + 2
B ← 0
BP ← BP + 1
END

FIG. 27

FIG. 28

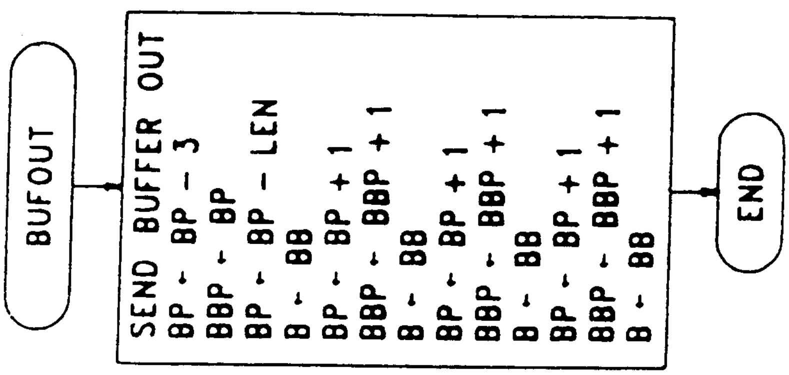


FIG. 29

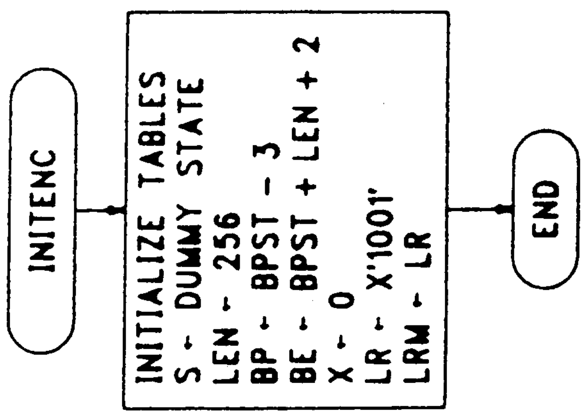


FIG. 30

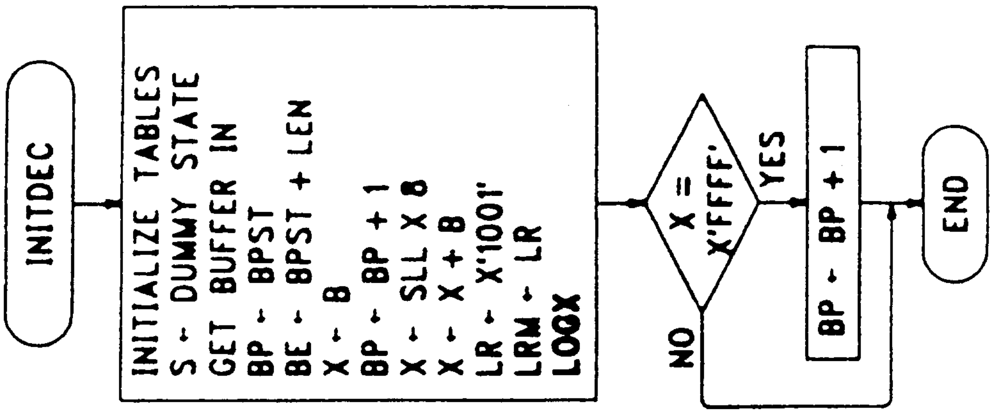

FIG. 31

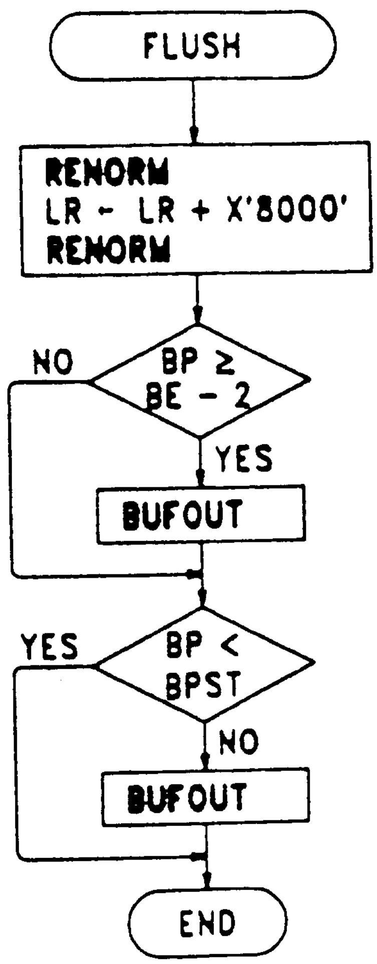
FLUSH
RENORM
LR ← LR + X'8000'
RENORM
NO
BP ≥ BE − 2
YES
BUFOUT
YES
BP < BPST
NO
BUFOUT
END